# EUROPEAN PATENT APPLICATION

(11) **EP 4 694 621 A1**
(43) Date of publication of application: **11.02.2026**
(21) Application number: 25183570.8
(22) Date of filing: 18.06.2025
(51) Int. Cl.: H10D 84/01, H10D 84/40, H10D 84/80

(54) **SEMICONDUCTOR DEVICE**

(30) Priority: 09.08.2024 KR 20240106999
(71) Applicant: SAMSUNG ELECTRONICS CO., LTD., Yeongtong-gu Suwon-si, Gyeonggi-do 16677 (KR)
(72) Inventor: CHO, Keunhwi, 16677 Suwon-si, Gyeonggi-do (KR); SONG, Inhyun, 16677 Suwon-si, Gyeonggi-do (KR); EOM, Byeolhae, 16677 Suwon-si, Gyeonggi-do (KR); UHM, Taewoo, 16677 Suwon-si, Gyeonggi-do (KR); SHIN, Donggwan, 16677 Suwon-si, Gyeonggi-do (KR); KIM, Dongwon, 16677 Suwon-si, Gyeonggi-do (KR); LEE, Kyoungwoo, 16677 Suwon-si, Gyeonggi-do (KR); CHO, Hagju, 16677 Suwon-si, Gyeonggi-do (KR)
(74) Representative: Kuhnen & Wacker Patent- und Rechtsanwaltsbüro PartG mbB

(57) **Abstract**

An example semiconductor device (1) includes a transistor, a first device (15a), a back side insulating structure below the transistor and the first device (15a), a front side conductive structure on the transistor and the first device (15a), a passivation structure between the first device (15a) and the back side insulating structure, a back side conductive pattern between the back side insulating structure and the transistor, and a back side interconnection structure in the back side insulating structure and electrically connected with the back side conductive pattern. The first device (15a) includes a semiconductor body, including a first semiconductor region (5pa) having a first conductivity type and a second semiconductor region (5na) having a second conductivity type, a first semiconductor pattern (10pa) on the first semiconductor region (5pa), and a second semiconductor pattern (10na) on the second semiconductor region (5na).

## Description

### BACKGROUND

With increased demand for high performance, high speed, and/or multi-functionality of semiconductor devices, the integration of semiconductor devices increases. In order to manufacture semiconductor devices with fine patterns in response to the trend for high integration of semiconductor devices, it is desired to implement patterns having fine widths or fine gaps. Additionally, efforts have been made to develop semiconductor devices including transistors with channels having a three-dimensional structure in order to overcome the limitation of operating characteristics due to a size reduction of a planar MOSFET (metal oxide semiconductor FET).

### SUMMARY

The present disclosure relates to a semiconductor device that may increase integration and improve performance, and a method for forming the semiconductor device.

In some implementations, a semiconductor device includes: a transistor; a first device spaced apart from the transistor; a back side insulating structure disposed below the transistor and the first device; a front side conductive structure disposed on the transistor and the first device; a passivation structure disposed between the first device and the back side insulating structure; a back side conductive pattern disposed between the back side insulating structure and the transistor; and a back side interconnection structure embedded in the back side insulating structure and electrically connected to the back side conductive pattern. The transistor includes: a first source/drain pattern and a second source/drain pattern spaced apart from each other; active layers disposed between the first source/drain pattern and the second source/drain pattern and spaced apart from each other in a vertical direction; a gate electrode surrounding each of the active layers; and a gate dielectric layer between the gate electrode and the active layers, and the first device includes: a semiconductor body including a first semiconductor region having a first conductivity type and a second semiconductor region having a second conductivity type and forming a PN junction with the first semiconductor region; a first semiconductor pattern disposed on the first semiconductor region of the semiconductor body, having the first conductivity type, and having an impurity concentration higher than an impurity concentration of the first semiconductor region; and a second semiconductor pattern disposed on the second semiconductor region of the semiconductor body, having the second conductivity type, and having an impurity concentration higher than an impurity concentration of the second semiconductor region, and the passivation structure includes a first passivation layer in contact with a lower surface of the semiconductor body and a second passivation layer disposed below the first passivation layer, the second passivation layer has a thickness greater than a thickness of the first passivation layer, and one of the first conductivity type and the second conductivity type is a P-type, and the other thereof is an N-type.

In some implementations, a semiconductor device includes: a transistor; a first device spaced apart from the transistor; a back side insulating structure disposed below the transistor and the first device; a front side conductive structure disposed on the transistor and the first device; a passivation structure disposed between the first device and the back side insulating structure; a back side conductive pattern disposed between the back side insulating structure and the transistor; and a back side interconnection structure embedded in the back side insulating structure and electrically connected to the back side conductive pattern. The transistor includes: a first source/drain pattern and a second source/drain pattern spaced apart from each other; active layers disposed between the first source/drain pattern and the second source/drain pattern and spaced apart from each other in a vertical direction; a gate electrode surrounding each of the active layers; and a gate dielectric layer between the gate electrode and the active layers. The first device includes: a semiconductor body including a first semiconductor region having a first conductivity type and a second semiconductor region having a second conductivity type and forming a PN junction with the first semiconductor region; a first semiconductor pattern disposed on the first semiconductor region of the semiconductor body, having the first conductivity type, and having an impurity concentration higher than an impurity concentration of the first semiconductor region; and a second semiconductor pattern disposed on the second semiconductor region of the semiconductor body, having the second conductivity type, and having an impurity concentration higher than an impurity concentration of the second semiconductor region. At least a portion of one of the first and second semiconductor patterns is disposed at the same level as a portion of at least one of the first and second source/drain patterns, a lower surface of the semiconductor body is disposed on a level lower than a center between an upper surface and a lower surface of the back side conductive pattern, the passivation structure includes a high-κ dielectric layer having a dielectric constant higher than a dielectric constant of silicon oxide, and one of the first conductivity type and the second conductivity type is a P-type and the other thereof is an N-type.

In some implementations, a semiconductor device includes: a lower base; and a semiconductor chip disposed on the lower base and electrically connected to the lower base. The semiconductor chip includes: a transistor; a first device spaced apart from the transistor; a back side insulating structure disposed below the transistor and the first device; a front side conductive structure disposed on the transistor and the first device; a passivation structure disposed between the first device and the back side insulating structure; a back side conductive pattern disposed between the back side insulating structure and the transistor; and a back side interconnection structure embedded in the back side insulating structure and electrically connected to the back side conductive pattern. The transistor includes: a first source/drain pattern and a second source/drain pattern spaced apart from each other; active layers disposed between the first source/drain pattern and the second source/drain pattern, and spaced apart from each other in a vertical direction; a gate electrode surrounding each of the active layers; and a gate dielectric layer between the gate electrode and the active layers, and the first device includes: a semiconductor body including a first semiconductor region having a first conductivity type and a second semiconductor region having a second conductivity type and forming a PN junction with the first semiconductor region; a first semiconductor pattern disposed on the first semiconductor region of the semiconductor body, having the first conductivity type, and having an impurity concentration higher than an impurity concentration of the first semiconductor region; and a second semiconductor pattern disposed on the second semiconductor region of the semiconductor body, having the second conductivity type, and having an impurity concentration higher than an impurity concentration of the second semiconductor region, and one of the first conductivity type and the second conductivity type is a P-type and the other thereof is an N-type, and the passivation structure is disposed outside an area between the back side insulating structure and the transistor.

### BRIEF DESCRIPTION OF THE DRAWINGS

The above and other aspects, features, and advantages of the present disclosure will be more clearly understood from the following detailed description, taken in conjunction with the accompanying drawings.
FIG. 1, FIG. 2A, FIG. 2B, FIG. 3A, FIG. 3B, FIG. 4A, FIG. 4B, FIG. 5A, FIG. 5B, FIG. 6, FIG. 7A, and FIG. 7B are views illustrating an example of a semiconductor device.
FIG. 8 is a cross-sectional view illustrating an example of a semiconductor device.
FIG. 9 is a cross-sectional view illustrating an example of a semiconductor device.
FIG. 10 is a cross-sectional view illustrating an example of a semiconductor device.
FIG. 11 is a cross-sectional view illustrating an example of a semiconductor device.
FIG. 12 and FIG. 13 are views illustrating an example of a semiconductor device.
FIG. 14 and FIG. 15 are views illustrating an example of a semiconductor device.
FIG. 16 and FIG. 17 are views illustrating an example of a semiconductor device.
FIGS. 18 and 19 are views illustrating an example of a semiconductor device.
FIG. 20 is a cross-sectional view illustrating an example of a semiconductor device.
FIG. 21 is a cross-sectional view illustrating an example of a semiconductor device.
FIG. 22A is a cross-sectional view illustrating an example of a semiconductor device.
FIG. 22B is a cross-sectional view illustrating an example of a semiconductor device.
FIG. 23 is a cross-sectional view illustrating an example of a semiconductor device.
FIG. 24 is a cross-sectional view illustrating an example of a semiconductor device.
FIG. 25 is a cross-sectional view illustrating an example of a semiconductor device.
FIG. 26 is a cross-sectional view illustrating an example of a semiconductor device.
FIG. 27 is a cross-sectional view illustrating an example of a semiconductor device.
FIG. 28 is a cross-sectional view illustrating an example of a semiconductor device.
FIG. 29 is a cross-sectional view illustrating an example of a semiconductor device.
FIG. 30 is a cross-sectional view illustrating an example of a semiconductor device.
FIG. 31, FIG. 32A, FIG. 32B, FIG. 33A, FIG. 33B, FIG. 34A, and FIG. 34B are views illustrating an example of a method for forming a semiconductor device.

### DETAILED DESCRIPTION

Hereinafter, the terms such as "upper," "intermediate," and "lower" may be replaced with other terms such as "first," "second," and "third" and may be used to describe elements of the specification. The terms such as "first," "second," and "third" may be used to describe various elements, but the elements are not limited to the terms, and the "first element" may be termed "second element." In the specification, the terms such as "a lower portion," "an upper portion," "an upper end," "a lower end," and the like, may be terms described based on drawings.

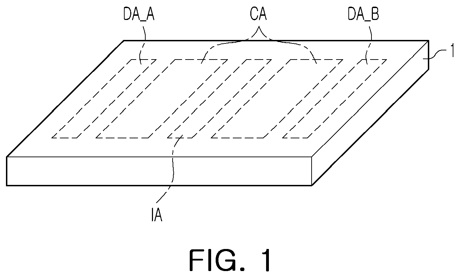

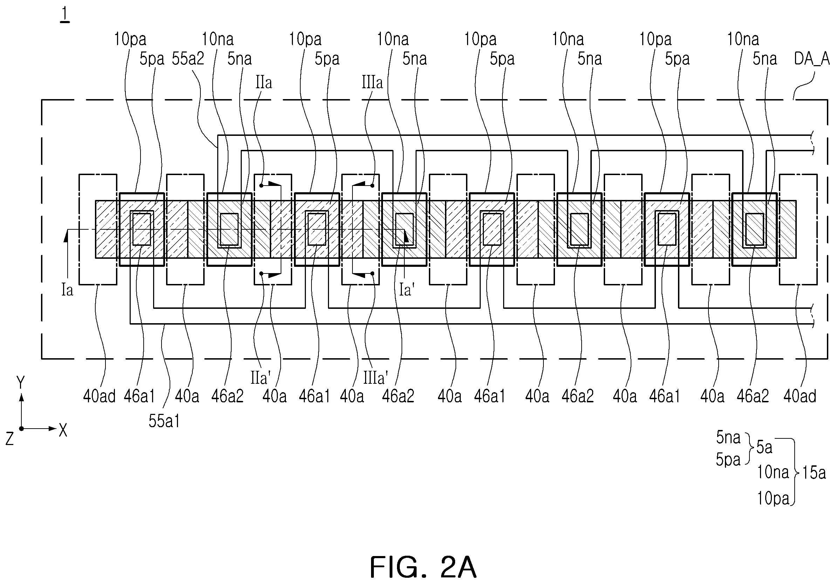

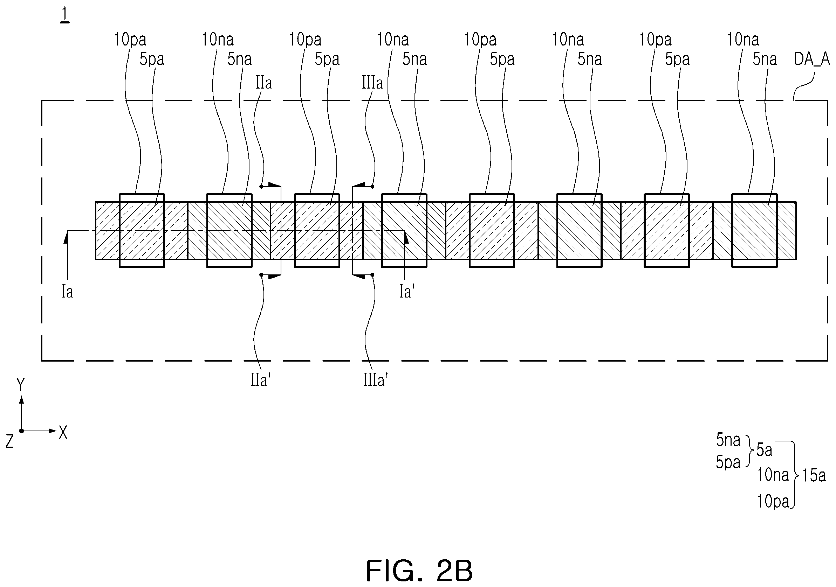

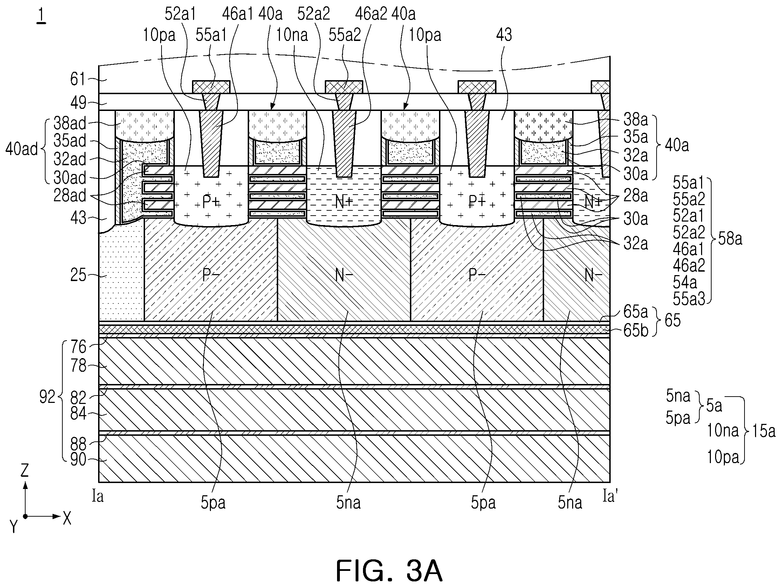

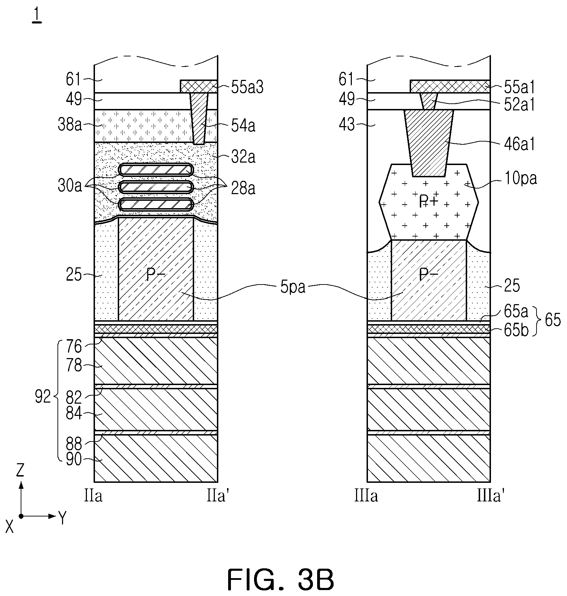

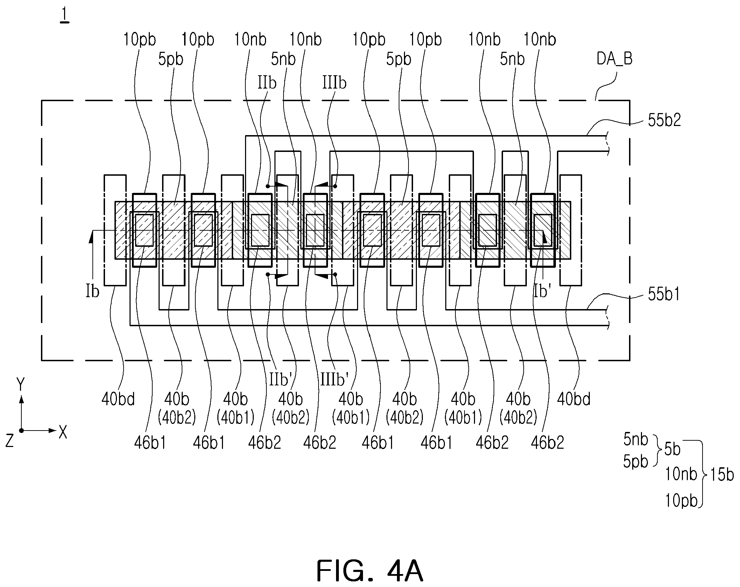

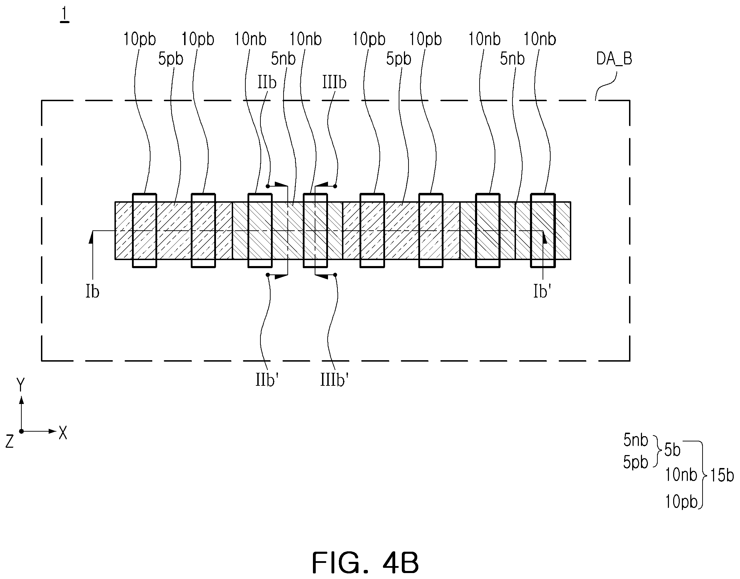

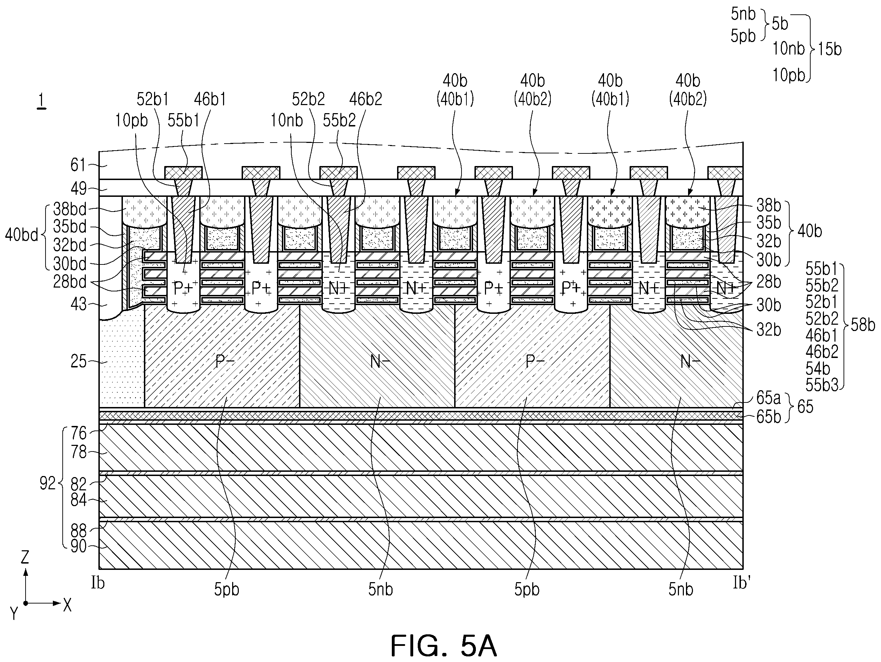

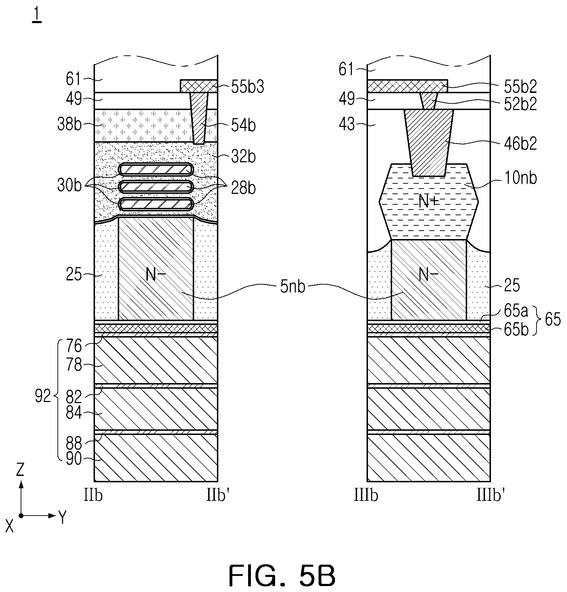

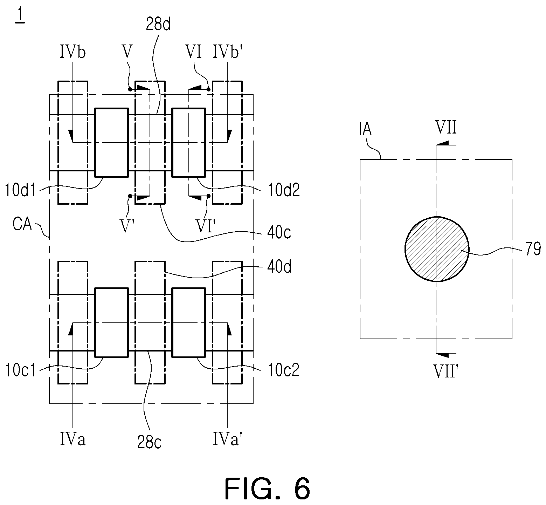

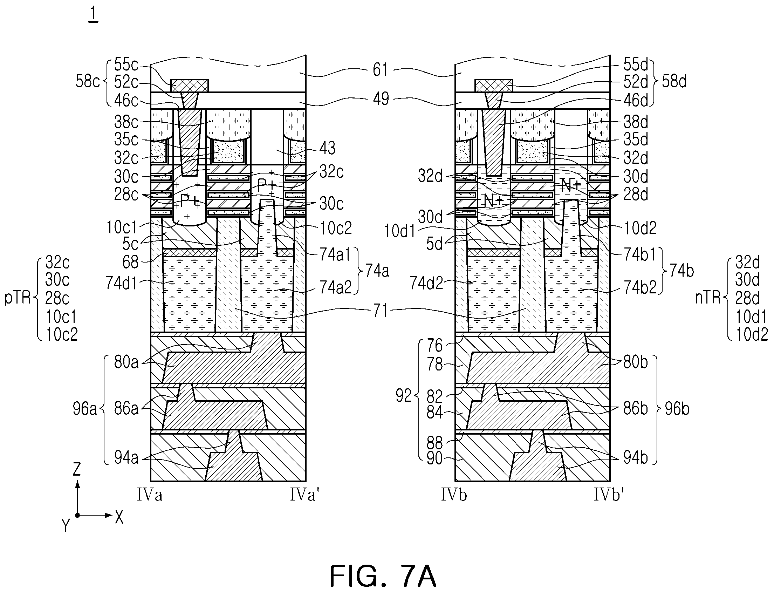

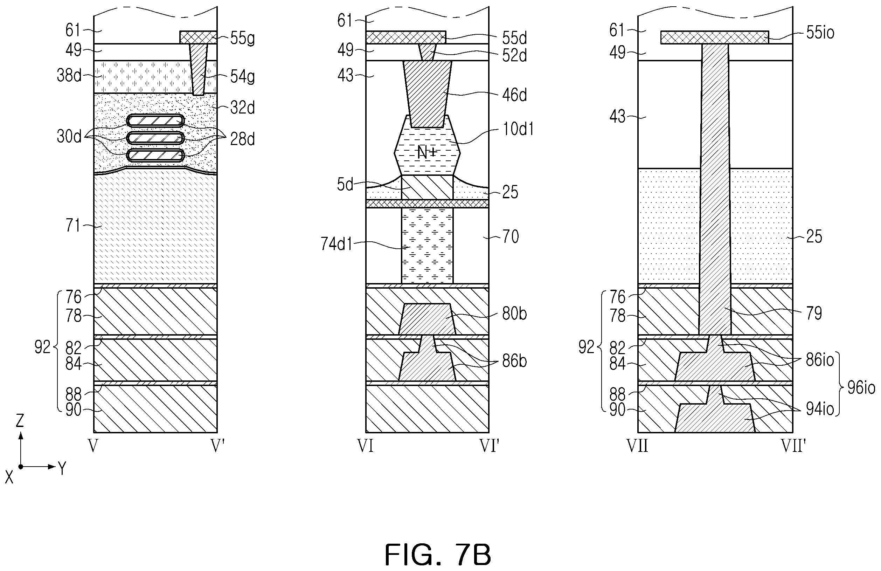

Referring to FIG. 1, FIG. 2A, FIG. 2B, FIG. 3A, FIG. 3B, FIG. 4A, FIG. 4B, FIG. 5A, FIG. 5B, FIG. 6, FIG. 7A, and FIG. 7B, an example of a semiconductor device will be described. In FIGS. 1 to 7B, FIG. 1 is a conceptual perspective view illustrating an example of a semiconductor device 1, FIG. 2A is a plan view illustrating a portion of a first device region DA _A of the semiconductor device 1, FIG. 2B is a plan view illustrating a portion of a device of FIG. 2A, FIG. 3A is a cross-sectional view illustrating a region taken along line Ia-Ia' of FIG. 2A, FIG. 3B is a cross-sectional view illustrating regions taken along lines IIa-IIa' and IIIa-IIIa' of FIG. 2A, FIG. 4A is a plan view illustrating a portion of a second device region DA_B of a semiconductor device 1, FIG. 4B is a plan view illustrating a portion of a device of FIG. 4A, FIG. 5A is a cross-sectional view illustrating a region taken along line Ib-Ib' of FIG. 4A, FIG. 5B is a cross-sectional view illustrating regions taken along lines IIb-IIb' and IIIb-IIIb' of FIG. 4A, FIG. 6 is a plan view illustrating a portion of a transistor region CA of a semiconductor device 1 and a portion of a connection region IA of a semiconductor device 1, FIG. 7A is a cross-sectional view illustrating regions taken along lines IVa-IVa' and IVb-IVb' of FIG. 6, and FIG. 7B is a cross-sectional view illustrating regions taken along lines V-V', VI-VI', and VII-VII' of FIG. 6.

First, referring to FIG. 1, the semiconductor device 1 may include a plurality of device regions DA_A and DA_B, a transistor region CA, and a connection region IA.

The plurality of device regions DA_A and DA_B may include a first device region DA_A and a second device region DA_B.

The plurality of device regions DA_A and DA_B may be regions including devices using a PN junction. For example, the plurality of device regions DA_A and DA_B may include at least one of: a first diode of a lateral PN (LPN) type in which a side surface of a P-type semiconductor region and a side surface of an N-type semiconductor region are joined; a second diode of a vertical PN (VPN) type in which the P-type semiconductor region and the N-type semiconductor region are joined in a vertical direction; Bipolar Junction Transistor (BJT) devices of PNP-type; and BJT devices of NPN-type.

The transistor region CA may be a region including transistors such as a MOSFET including a source, a drain, a channel region, and a gate. For example, the transistor region CA may include a transistor having a MBCFET^{™} (Multi Bridge Channel FET) structure, which is a gate-all-around type field effect transistor. The connection region IA may be a region for routing input/output signals. The transistor region CA may include a front side conductive structure disposed on the transistors and a back side interconnection structure disposed below the transistors.

Next, referring to FIG. 1, FIG. 2A, FIG. 2B, FIG. 3A and FIG. 3B, an example of the first device region DA_A of the semiconductor device 1 will be described.

Referring to FIG. 1, FIG. 2A, FIG. 2B, FIG. 3A and FIG. 3B, the first device region DA_A of the semiconductor device 1 may include a first device 15a.

The first device 15a may include a first semiconductor body 5a, a first semiconductor pattern 10pa, and a second semiconductor pattern 10na.

The first semiconductor body 5a may be formed of a semiconductor material. For example, the first semiconductor body 5a may include at least one of silicon (Si), silicon germanium (SiGe), germanium (Ge), and silicon carbide (SiC). For example, the first semiconductor body 5a may include single crystal silicon.

The first semiconductor body 5a may include a first semiconductor region 5pa having a first conductivity type, and a second semiconductor region 5na having a second conductivity type and forming a PN junction with the first semiconductor region Spa.

In an example, one of the first conductivity type and the second conductivity type may be a P-type conductivity type, and the other may be an N-type conductivity type. For example, the first conductive type may be a P-type conductive type, and the second conductive type may be an N-type conductive type. In another example, the first conductive type may be an N-type conductive type, and the second conductive type may be a P-type conductive type.

The first semiconductor pattern 10pa may be connected to the first semiconductor region Spa on the first semiconductor region Spa, and the second semiconductor pattern 10na may be connected to the second semiconductor region 5na on the second semiconductor region 5na.

In some implementations, the first semiconductor region 5pa may be provided in plural, the second semiconductor region 5na may be provided in plural, the first semiconductor pattern 10pa may be provided in plural, and the second semiconductor pattern 10na may be provided in plural.

The first semiconductor body 5a may have a bar shape extending in a first direction (X-direction). The first semiconductor regions Spa and the second semiconductor regions 5na may be alternately arranged in the first direction (X-direction).

The first semiconductor patterns 10pa may be disposed on the first semiconductor regions Spa of the first semiconductor body 5a, and may have the first conductivity type. One first semiconductor pattern 10pa, among the first semiconductor patterns 10pa, may be disposed on one first semiconductor region Spa among the first semiconductor regions 5pa. A width of each of the first semiconductor patterns 10pa in the first direction (X-direction) may be less than a width of each of the first semiconductor regions Spa in the first direction (X-direction). The first semiconductor patterns 10pa and the first semiconductor regions Spa may have the same conductivity type, for example, a P-type conductivity type. The first semiconductor patterns 10pa and the first semiconductor regions Spa may be doped with impurities such as elements of Group 13 of the periodic table, for example, B or Al. An impurity concentration of the first semiconductor patterns 10pa may be higher than an impurity concentration of the first semiconductor regions 5pa. The first semiconductor patterns 10pa may be formed with an epitaxial layer epitaxially grown from the first semiconductor body 5a. Each of the first semiconductor patterns 10pa may include at least one of silicon, silicon germanium, and germanium.

The second semiconductor patterns 10na may be disposed on the second semiconductor regions 5na of the first semiconductor body 5a, and may have the second conductivity type. One second semiconductor pattern 10na, among the second semiconductor patterns 10na, may be disposed on one second semiconductor region 5na among the second semiconductor regions 5na. A width of each of the second semiconductor patterns 10na in the first direction (X-direction) may be less than a width of each of the second semiconductor regions 5na in the first direction (X-direction). The second semiconductor patterns 10na and the second semiconductor regions 5na may have the same conductivity type, for example, an N-type conductivity type. The second semiconductor patterns 10na and the second semiconductor regions 5na may be doped with impurities such as elements of Group 15 of the Periodic Table, for example, P or As. An impurity concentration of the second semiconductor patterns 10na may be higher than an impurity concentration of the second semiconductor regions 5na. The second semiconductor patterns 10na may be formed with an epitaxial layer epitaxially grown from the first semiconductor body 5a. Each of the second semiconductor patterns 10na may include silicon.

In an example, the first semiconductor patterns 10pa may include silicon germanium, and the second semiconductor patterns 10na may not include silicon germanium.

Throughout the drawing, a region indicated as N- may be an N-type low-concentration semiconductor region having an N-type conductivity and a relatively low impurity concentration, a region indicated as P- may be a P-type low-concentration semiconductor region having a P-type conductivity and a relatively low impurity concentration, a region indicated as N+ may be an N-type high-concentration semiconductor region having an N-type conductivity and a relatively high impurity concentration, and a region indicated as P+ may be a P-type high-concentration semiconductor region having a P-type conductivity and a relatively high impurity concentration. Here, a low-concentration semiconductor region and a high-concentration semiconductor region may be defined by relative impurity concentrations in the semiconductor regions having the same conductivity.

The first device region DA_A of the semiconductor device 1 may further include first dummy active structures 28a and 28ad. The first dummy active structures 28a and 28ad may include first edge dummy active structures 28ad and first dummy active structures 28a between the first edge dummy active structures 28ad. Each of the first edge dummy active structures 28ad may include first edge dummy active layers spaced apart from each other in a vertical direction (Z-direction). Each of the first dummy active structures 28a may include first dummy active layers spaced apart from each other in the vertical direction (Z-direction). The first edge dummy active layers and the first dummy active layers of the first dummy active structures 28a and 28ad may be formed of a semiconductor material. For example, the first edge dummy active layers and the first dummy active layers of the first dummy active structures 28a and 28ad may include at least one of silicon, silicon germanium, germanium, and silicon carbide.

Each of the first and second semiconductor patterns 10pa and 10na may be disposed between dummy active structures 28a and 28ad adjacent to each other, among the dummy active structures 28a and 28ad. The first dummy active structures 28a may be disposed between semiconductor patterns adjacent to each other, among the first and second semiconductor patterns 10pa and 10na. The dummy active structures 28a and 28ad may be connected to the first and second semiconductor patterns 10pa and 10na.

The first device region DA_A of the semiconductor device 1 may further include a device isolation layer 25 on a side surface of the first semiconductor body 5a. The device isolation layer 25 may surround a side surface of the first semiconductor body 5a. The device isolation layer 25 may be formed of an insulating material.

The first device region DA_A of the semiconductor device 1 may further include first gate structures 40a and 40ad.

The first gate structures 40a and 40ad may include first edge gate structures 40ad and first gate structures 40a disposed between the first edge gate structures 40ad. Each of the first edge gate structures 40ad may be disposed on the first semiconductor body 5a and the device isolation layer 25.

The first edge gate structures 40ad may include a portion vertically overlapping the first edge dummy active structures 28ad. Each of the first edge gate structures 40ad may include a gate electrode 32ad respectively surrounding first edge active layers of the first edge active structure 28ad, an insulating spacer 35ad on a side surface of the gate electrode 32ad, a gate dielectric layer 30ad disposed between the gate electrode 32ad and the first edge active layers of the first edge active structure 28ad, covering a bottom surface of the gate electrode 32ad, and disposed between the gate electrode 32ad and the insulating spacer 35ad, and an insulating capping pattern 38ad on the gate electrode 32ad.

The first gate structures 40a may vertically overlap the first dummy active structures 28a. Each of the first gate structures 40a may include a gate electrode 32a surrounding each of the first dummy active layers of the first dummy active structure 28a, an insulating spacer 35a on a side surface of the gate electrode 32a, a gate dielectric layer 30a disposed between the gate electrode 32a and the first dummy active layers of the first dummy active structure 28a, covering the bottom surface of the gate electrode 32a, and disposed between the gate electrode 32a and the insulating spacer 35a, and an insulating capping pattern 38a on the gate electrode 32a.

The first gate structures 40a may be disposed on PN junction regions between the first semiconductor regions Spa and the second semiconductor regions 5na.

When the first device 15a is in operation or the first device 15a is turned off, a voltage that may suppress or prevent leakage current from flowing to the first dummy active layers of the first dummy active structures 28a disposed between the first and second semiconductor patterns 10pa and 10na may be applied to the gate electrodes 32a of the first gate structures 40a. For example, approximately 0 V may be applied to the gate electrodes 32a of the first gate structures 40a. Accordingly, the first gate structures 40a may improve performance of the first device 15a.

The first device region DA_A of the semiconductor device 1 may further include a first interlayer insulating layer 43 disposed on the first and second semiconductor patterns 10pa and 10na and the device isolation layer 25 and disposed on side surfaces of the first gate structures 40a and 40ad, a second interlayer insulating layer 49 disposed on the first gate structures 40a and 40ad and the first interlayer insulating layer 43, and a front insulating structure 61 on the second interlayer insulating layer 49.

The first device region DA_A of the semiconductor device 1 may further include a first front side conductive structure 58a.

The first front side conductive structure 58a may include first lower contact plugs 46a1 penetrating through the first interlayer insulating layer 43 and electrically connected to the first semiconductor patterns 10pa, and second lower contact plugs 46a2 penetrating through the first interlayer insulating layer 43 and electrically connected to the second semiconductor patterns 10na.

The first front side conductive structure 58a may include first upper contact plugs 52a1 penetrating through the second interlayer insulating layer 49 and electrically connected to the first lower contact plugs 46a1, and second upper contact plugs 52a2 penetrating through the second interlayer insulating layer 49 and electrically connected to the second lower contact plugs 46a2.

The first front side conductive structure 58a may further include a gate contact plug 54a penetrating the second interlayer insulating layer 49 and the insulating capping pattern 38a and electrically connected to the gate electrode 32a.

The first front side conductive structure 58a may further include a first interconnection 55a1 electrically connected to the first upper contact plugs 52a1, a second interconnection 55a2 electrically connected to the second upper contact plugs 52a2, and a gate interconnection 55a3 electrically connected to the gate contact plug 54a, on the second interlayer insulating layer 49.

The front insulating structure 61 may cover the first interconnection 55a1, the second interconnection 55a2 and the gate interconnection 55a3.

In an example, the first interconnection 55a1 and the second interconnection 55a2 may be disposed so that the first device 15a forms a PN diode as in FIG. 2A. However, the example implementation is not limited thereto. For example, the first and second interconnections 55a1 and 55a2 may be modified in various forms so that the first device 15a may be configured as a PNP BJT device or an NPN BJT device. Accordingly, the first device 15a may be configured as a PN diode, a PNP BJT device, or an NPN BJT device, depending on the form of the first front side conductive structure 58a.

The first device region DA_A of the semiconductor device 1 may further include a back side insulating structure 92 disposed below the first device 15a and a passivation structure 65 disposed between the back side insulating structure 92 and the first device 15a.

The back side insulating structure 92 may include a first back side etch stop layer 76, a first back side interlayer insulating layer 78, a second back side etch stop layer 82, a second back side interlayer insulating layer 84, a third back side etch stop layer 88, and a third back side interlayer insulating layer 90, which are sequentially disposed in a direction away from the passivation structure 65. The first, second, and third back side interlayer insulating layers 78, 84 and 90 may include silicon oxide or a low-κ dielectric having a dielectric constant lower than a dielectric constant of silicon oxide. The first, second, and third back side etch stop layers 76, 82 and 88 may include a material other than silicon oxide or the low-x dielectric. For example, the first, second, and third back side etch stop layers 76, 82 and 88 may include an insulating material such as SiN, SiBN, SiCN, or AlN.

The passivation structure 65 may include a first passivation layer 65a in contact with a lower surface of the first semiconductor body 5a and a second passivation layer 65b disposed below the first passivation layer 65a. The second passivation layer 65b may have a thickness greater than a thickness of the first passivation layer 65a.

In an example, the thickness of the first passivation layer 65a may be in the range of 0.5 nm to 1.5 nm, and a thickness of the second passivation layer 65b may be in the range of 1 nm to 100 nm.

The first passivation layer 65a may include a first dielectric, and the second passivation layer 65b may include a second dielectric having a dielectric constant higher than a dielectric constant of the first dielectric, and having fixed charges. The first passivation layer 65a may be an oxide layer, and the second passivation layer 65b may be a high-κ dielectric layer having a dielectric constant higher than a dielectric constant of silicon oxide and having fixed charges. For example, the first passivation layer 65a may be a silicon oxide layer, and the second passivation layer 65b may include at least one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

The first passivation layer 65a is in contact with the lower surface of the first semiconductor body 5a and may reduce surface defects, such as dangling bonds, of the lower surface of the first semiconductor body 5a. Since the second passivation layer 65b may be formed of a high-κ dielectric having fixed charges, the second passivation layer 65b may affect the charge distribution near the lower surface of the first semiconductor body 5a and may control surface charge density. Accordingly, the second passivation layer 65b may reduce the probability of recombination in the lower surface of the first semiconductor body 5a.

Accordingly, the passivation structure 65 including the first passivation layer 65a and the second passivation layer 65b may prevent or reduce leakage current due to Generation-Recombination Current (the G-R current) that may occur on the lower surface of the first semiconductor body 5a of the first device 15a. Accordingly, the passivation structure 65 may improve the performance of the first device 15a.

With reference to FIGS. 4A, 4B, 5A and 5B along with FIGS. 1 to 3B, an example of the second device region DA_B of the semiconductor device 1 will be described.

With reference to FIGS. 4A, 4B, 5A and 5B along with FIGS. 1 to 3B described above, the second device region DA_B of the semiconductor device 1 may include a second device 15b.

The second device 15b may include a second semiconductor body 5b, a third semiconductor pattern 10pb, and a fourth semiconductor pattern 10nb.

The second semiconductor body 5b may be formed of the same semiconductor material as the first semiconductor body 5a.

The second semiconductor body 5b may include a third semiconductor region 5pb having the first conductive type and a fourth semiconductor region 5nb having the second conductive type and forming a PN junction with the third semiconductor region 5pb.

The third semiconductor pattern 10pb may be connected to the third semiconductor region 5pb on the third semiconductor region 5pb, and the fourth semiconductor pattern 10nb may be connected to the fourth semiconductor region 5nb on the fourth semiconductor region 5nb.

In some implementations, the third semiconductor region 5pb may be provided in plural, the fourth semiconductor region 5nb may be provided in plural, the third semiconductor pattern 10pb may be provided in plural, and the fourth semiconductor pattern 10nb may be provided in plural.

The second semiconductor body 5b may have a bar shape extending in the first direction (X-direction). The third semiconductor regions 5pb and the fourth semiconductor regions 5nb may be alternately arranged in the first direction (X-direction).

The third semiconductor patterns 10pb may be disposed on the third semiconductor regions 5pb of the second semiconductor body 5b, and may have the first conductivity type. A plurality of third semiconductor patterns among the third semiconductor patterns 10pb may be disposed on one third semiconductor region among the third semiconductor regions 5pb. For example, two third semiconductor patterns among the third semiconductor patterns 10pb may be disposed on one third semiconductor region among the third semiconductor regions 5pb.

A width of each of the third semiconductor patterns 10pb in the first direction (X-direction) may be less than a width of each of the third semiconductor regions 5pb in the first direction (X-direction). The third semiconductor patterns 10pb and the third semiconductor regions 5pb may have the same conductivity type, for example, a P-type conductivity type. An impurity concentration of the third semiconductor patterns 10pb may be higher than an impurity concentration of the third semiconductor regions 5pb. The third semiconductor patterns 10pb may be formed with an epitaxial layer epitaxially grown from the second semiconductor body 5b. Each of the third semiconductor patterns 10pb may include at least one of silicon, silicon germanium, and germanium.

The fourth semiconductor patterns 10nb may be disposed on the fourth semiconductor regions 5nb of the second semiconductor body 5b, and may have the second conductivity type. A plurality of fourth semiconductor patterns among the fourth semiconductor patterns 10nb may be disposed on one fourth semiconductor region among the fourth semiconductor regions 5nb. For example, two fourth semiconductor patterns among the fourth semiconductor patterns 10nb may be disposed on one fourth semiconductor region among the fourth semiconductor regions 5nb. A width of each of the fourth semiconductor patterns 10nb in the first direction (X-direction) may be less than a width of each of the fourth semiconductor regions 5nb in the first direction (X-direction). The fourth semiconductor patterns 10nb and the fourth semiconductor regions 5nb may have the same conductivity type, for example, an N-type conductivity type. An impurity concentration of the fourth semiconductor patterns 10nb may be higher than an impurity concentration of the fourth semiconductor regions 5nb. The fourth semiconductor patterns 10nb may be formed with an epitaxial layer epitaxially grown from the second semiconductor body 5b. Each of the fourth semiconductor patterns 10nb may include silicon.

In an example, the third semiconductor patterns 10pb may include silicon germanium, and the fourth semiconductor patterns 10nb may not include silicon germanium.

In an example, a width of each of the third and fourth semiconductor patterns 10pb and 10nb may be smaller than a width of each of the first and second semiconductor patterns 10pa and 10na.

The second device region DA_B of the semiconductor device 1 may further include second dummy active structures 28b and 28bd. The second dummy active structures 28b and 28bd may include second edge dummy active structures 28bd and second dummy active structures 28b between the second edge dummy active structures 28bd. Each of the second edge dummy active structures 28bd may include second edge dummy active layers spaced apart from each other in a vertical direction (Z-direction). Each of the second dummy active structures 28b may include second dummy active layers spaced apart from each other in the vertical direction (Z-direction). The second edge dummy active layers and the second dummy active layers of the second dummy active structures 28b and 28bd may be formed of a semiconductor material. For example, the second edge dummy active layers and the second dummy active layers of the second dummy active structures 28b and 28bd may include at least one of silicon, silicon germanium, and germanium.

Each of the third and fourth semiconductor patterns 10pb and 10nb may be disposed between dummy active structures 28b and 28bd adjacent to each other, among the dummy active structures 28b and 28bd. The second dummy active structures 28b may be disposed between semiconductor patterns adjacent each other, among the third and fourth semiconductor patterns 10pb and 10nb. The dummy active structures 28b and 28bd may be connected to the third and fourth semiconductor patterns 10pb and 10nb.

The second device region DA_B of the semiconductor device 1 may further include a device isolation layer 25. The device isolation layer 25 may be disposed on a side surface of the second semiconductor body 5b. The device isolation layer 25 may surround a side surface of the second semiconductor body 5b. The device isolation layer 25 may be formed of an insulating material.

The second device region DA_B of the semiconductor device 1 may further include second gate structures 40b and 40bd.

The second gate structures 40b and 40bd may include second edge gate structures 40bd and second gate structures 40b disposed between the second edge gate structures 40bd. Each of the second edge gate structures 40bd may be disposed on the second semiconductor body 5b and the device isolation layer 25.

The second edge gate structures 40bd may include a portion vertically overlapping the second edge dummy active structures 28bd. Each of the second edge gate structures 40bd may include a gate electrode 32bd surrounding each of the second edge active layers of the second edge active structure 28bd, an insulating spacer 35bd on a side surface of the gate electrode 32bd, a gate dielectric layer 30bd disposed between the gate electrode 32bd and the second edge active layers of the second edge active structure 28bd, covering a lower surface of the gate electrode 32bd and disposed between the gate electrode 32bd and the insulating spacer 35bd, and an insulating capping pattern 38bd on the gate electrode 32bd.

The second gate structures 40b may vertically overlap the second dummy active structures 28b. Each of the second gate structures 40b may include a gate electrode 32b surrounding each of the second dummy active layers of the second dummy active structure 28b, an insulating spacer 35b on a side surface of the gate electrode 32b, a gate dielectric layer 30b disposed between the gate electrode 32b and the second dummy active layers of the second dummy active structure 28b, covering the lower surface of the gate electrode 32b, and disposed between the gate electrode 32b and the insulating spacer 35b, and an insulating capping pattern 38b on the gate electrode 32b.

The second gate structures 40b may include second-first gate structures 40b1 and second-second gate structures 40b2. The second-first gate structures 40b 1 may be disposed on PN junction regions between the third semiconductor regions 5pb and the fourth semiconductor regions 5nb. The second-second gate structures 40b2 may be disposed on regions other than the PN junction regions, that is, on the third semiconductor regions 5pb and the fourth semiconductor regions 5nb.

When the second device 15b is in operation or the second device 15b is turned off, a voltage that may suppress or prevent leakage current from flowing to the second dummy active layers of the second dummy active structures 28b disposed between the third and fourth semiconductor patterns 10pb and 10nb may be applied to the gate electrodes 32b of the second-first gate structures 40b1. For example, approximately 0 V may be applied to the gate electrodes 32b of the second-first gate structures 40b1. Accordingly, the second gate structures 40b may improve the performance of the second device 15b.

The second device region DA_B of the semiconductor device 1 may further include the first interlayer insulating layer 43, the second interlayer insulating layer 49, and the front insulating structure 61. The first interlayer insulating layer 43 may be disposed on the first and second semiconductor patterns 10pa and 10na and the device isolation layer 25 and may be disposed on side surfaces of the second gate structures 40b and 40bd. The second interlayer insulating layer 49 may be disposed on the first interlayer insulating layer 43 and the second gate structures 40b and 40bd.

The second device region DA_B of the semiconductor device 1 may further include a second front side conductive structure 58b.

The second front side conductive structure 58b may include third lower contact plugs 46b1 penetrating through the first interlayer insulating layer 43 and electrically connected to the third semiconductor patterns 10pb, and fourth lower contact plugs 46b2 penetrating through the first interlayer insulating layer 43 and electrically connected to the fourth semiconductor patterns 10nb.

The second front side conductive structure 58b may include third upper contact plugs 52b1 penetrating through the second interlayer insulating layer 49 and electrically connected to the third lower contact plugs 46b1, and fourth upper contact plugs 52b2 penetrating through the second interlayer insulating layer 49 and electrically connected to the fourth lower contact plugs 46b2.

The second front side conductive structure 58b may further include a gate contact plug 54b penetrating the second interlayer insulating layer 49 and the insulating capping pattern 38b and electrically connected to the gate electrode 32b.

The second front side conductive structure 58b may further include a third interconnection 55b1 electrically connected to the third upper contact plugs 52b1, a fourth interconnection 55b2 electrically connected to the fourth upper contact plugs 52b2, and a gate interconnection 55b3 electrically connected to the gate contact plug 54b, on the second interlayer insulating layer 49.

The front insulating structure 61 may cover the third interconnection 55b1, the fourth interconnection 55b2, and the gate interconnection 55b3.

In an example, the third interconnection 55b1 and the fourth interconnection 55b2 may be disposed so that the second device 15b forms a PN diode as in FIG. 4A. However, the example implementation is not limited thereto. For example, the third and fourth interconnections 55b1 and 55b2 may be modified in various forms so that the second device 15b may be configured as a PNP BJT device or an NPN BJT device. Accordingly, the second device 15b may be configured as a PN diode, a PNP BJT device, or an NPN BJT device depending on the form of the second front side conductive structure 58b.

The second device region DA_B of the semiconductor device 1 may further include the back side insulating structure 92 and the passivation structure 65. The back side insulating structure 92 may be disposed below the second device 15b. The passivation structure 65 may be disposed between the back side insulating structure 92 and the second device 15b. The passivation structure 65 may be disposed below the first device 15a and the second device 15b, and the back side insulating structure 92 may be disposed below the passivation structure 65.

As identically described above, the passivation structure 65 may include the first passivation layer 65a in contact with a lower surface of the second semiconductor body 5b and the second passivation layer 65b disposed below the first passivation layer 65a. Accordingly, the passivation structure 65 disposed below the first device 15a may improve the performance of the first device 15a, and the passivation structure 65 disposed below the second device 15b may improve the performance of the second device 15b.

At least one of the first device 15a and the second device 15b having improved performance in this manner may be used for a Band Gap Reference (BGR) or a temperature sensor, so that the performance of the semiconductor device 1 including the Band Gap Reference (BGR) or a temperature sensor may be improved.

With reference to FIGS. 6, 7A and 7B along with FIGS. 1 to 5B, examples of the transistor region CA and the connection region IA of the semiconductor device 1 will be described.

Referring to FIGS. 6, 7A, and 7B along with FIGS. 1 to 5B described above, the transistor region CA of the semiconductor device 1 may include a first transistor pTR and a second transistor nTR. The first transistor pTR may be a PMOS transistor, and the second transistor nTR may be an NMOS transistor.

The first transistor pTR may include a first source/drain pattern 10c1 and a second source/drain pattern 10c2 spaced apart from each other, first active layers 28c disposed between the first source/drain pattern 10c1 and the second source/drain pattern 10c2 and spaced apart from each other in the vertical direction (Z-direction), a gate electrode 32c surrounding each of the first active layers 28c, and a gate dielectric layer 30c between the gate electrode 32c and the first active layers 28c. The gate dielectric layer 30c may cover a lower surface and a side surface of the gate electrode 32c. The first active layers 28c may be channel layers. The first active layers 28c may include a semiconductor material, for example, at least one of silicon, silicon germanium, germanium, and silicon carbide. The first source/drain pattern 10c1 and the second source/drain pattern 10c2 may be formed of a semiconductor material having a P-type conductivity. The first source/drain pattern 10c1 and the second source/drain pattern 10c2 may include the same semiconductor material as the first semiconductor patterns 10pa and the third semiconductor patterns 10pb described above. For example, the first source/drain pattern 10c1 and the second source/drain pattern 10c2 may include epitaxial silicon germanium.

The second transistor nTR may include a third source/drain pattern 10d1 and a fourth source/drain pattern 10d2 spaced apart from each other, second active layers 28d disposed between the third source/drain pattern 10d1 and the fourth source/drain pattern 10d2 and spaced apart from each other in the vertical direction (Z-direction), a gate electrode 32d surrounding each of the second active layers 28d, and a gate dielectric layer 30d between the gate electrode 32d and the second active layers 28d. The gate dielectric layer 30d may cover a lower surface and a side surface of the gate electrode 32d. The second active layers 28d may be channel layers. The second active layers 28d may include a semiconductor material, for example, at least one of silicon, silicon germanium, germanium, and silicon carbide. The third source/drain pattern 10d1 and the fourth source/drain pattern 10d2 may be formed of a semiconductor material having an N-type conductivity. The third source/drain pattern 10d1 and the fourth source/drain pattern 10d2 may include the same semiconductor material as the second semiconductor patterns 10na and the third semiconductor patterns 10nb described above. For example, the third source/drain pattern 10d1 and the fourth source/drain pattern 10d2 may include epitaxial silicon and may not include epitaxial silicon germanium.

The first and second active layers 28c and 28d and the dummy active layers of the first and second dummy active structures 28a and 28b described above may be disposed at the same level.

At least a portion of at least one of the first to fourth source/drain patterns 10c1, 10c2, 10d1 and 10d2 may be disposed at the same level as at least a portion of at least one of the first to fourth semiconductor patterns 10pa, 10na, 10pb and 10nb.

The transistor region CA of the semiconductor device 1 further includes an insulating spacer 35c on the side surface of the gate electrode 32c of the first transistor pTR and an insulating capping pattern 38c on the gate electrode 32c, and may further include an insulating spacer 35d on the side surface of the gate electrode 32d of the second transistor nTR and an insulating capping pattern 38d on the gate electrode 32d.

The transistor region CA of the semiconductor device 1 may further include a first semiconductor layer 5c below the first transistor nTR and a second semiconductor layer 5d below the second transistor pTR. The first and second semiconductor layers 5c and 5d may be formed of the same semiconductor material as the first and second semiconductor bodies 5a and 5b.

The first and second semiconductor bodies 5a and 5b may be disposed at the same level and may have the same thickness. The first and second semiconductor layers 5c and 5d may be disposed at the same level and may have the same thickness. A thickness of each of the first and second semiconductor bodies 5a and 5b may be greater than a thickness of each of the first and second semiconductor layers 5c and 5d. Lower surfaces of the first and second semiconductor bodies 5a and 5b may be disposed on a lower level than lower surfaces of the first and second semiconductor layers 5c and 5d.

In an example, the passivation structure 65 may not be disposed below the first and second transistors pTR and nTR.

The transistor region CA of the semiconductor device 1 may further include the device isolation layer 25, the first interlayer insulating layer 43, the second interlayer insulating layer 49, and the front insulating structure 61.

The device isolation layer 25 may be disposed on side surfaces of the first and second semiconductor layers 5c and 5d. The first interlayer insulating layer 43 may be disposed on the device isolation layer 25 and the first to fourth source/drain patterns 10c1, 10c2, 10d1 and 10d2. The second interlayer insulating layer 49 may be disposed on the first interlayer insulating layer 43 and the insulating capping patterns 38c and 38d, and the front insulating structure 61 may be disposed on the second interlayer insulating layer 49.

The transistor region CA of the semiconductor device 1 may further include a third front side conductive structure 58c and a fourth front side conductive structure 58d.

The third front side conductive structure 58c may include a first lower contact plug 46c penetrating through the first interlayer insulating layer 43 and electrically connected to the first source/drain pattern 10c1, a first upper contact plug 52c penetrating through the second interlayer insulating layer 49 and electrically connected to the first lower contact plug 46c, and a first gate interconnection 55c electrically connected to the first upper contact plug 52c on the second interlayer insulating layer 49.

The fourth front side conductive structure 58d may include a second lower contact plug 46d penetrating through the first interlayer insulating layer 43 and electrically connected to the third source/drain pattern 10d1, a second upper contact plug 52d penetrating through the second interlayer insulating layer 49 and electrically connected to the second lower contact plug 46d, and a second gate interconnection 55d electrically connected to the second upper contact plug 52d on the second interlayer insulating layer 49.

The transistor region CA of the semiconductor device 1 may further include a gate contact plug 54g penetrating the second interlayer insulating layer 49 and the insulating capping pattern 38d and electrically connected to the gate electrode 32d, and a gate interconnection 55g electrically connected to the gate contact plug 54g on the second interlayer insulating layer 49.

The connection region IA of the semiconductor device 1 may include the device isolation layer 25, the first interlayer insulating layer 43 on the device isolation layer 25, the second interlayer insulating layer 49 on the first interlayer insulating layer 43, and the front insulating structure 61 on the second interlayer insulating layer 49.

The transistor region CA and the connection region IA of the semiconductor device 1 may further include the back side insulating structure 92. The back side insulating structure 92 may be disposed below the first and second transistors pTR and nTR and the device isolation layer 25.

The back side insulating structure 92 may be disposed at the same level in the transistor region CA, the connection region IA, the first device region DA_A and the second device region DA_B.

The transistor region CA of the semiconductor device 1 may include a first back side conductive pattern 74a disposed between the back side insulating structure 92 and the first transistor pTR, and a second back side conductive pattern 74b disposed between the back side insulating structure 92 and the second transistor nTR.

The transistor region CA of the semiconductor device 1 may further include a buffer insulating layer 68 disposed below lower surfaces of the first and second semiconductor layers 5c and 5d.

The first back side conductive pattern 74a may include a first portion 74a2 disposed below the buffer insulating layer 68, and a second portion 74a1 extending upwardly from the first portion 74a2 to penetrate through the buffer insulating layer 68 and the first semiconductor layer 5c and electrically connected to the second source/drain pattern 10c2. The first back side conductive pattern 74a may be a first back side source/drain contact plug.

The second back side conductive pattern 74b may include a first portion 74b2 disposed below the buffer insulating layer 68, and a second portion 74b1 extending upwardly from the first portion 74b2 to penetrate through the buffer insulating layer 68 and the second semiconductor layer 5d and electrically connected to the fourth source/drain pattern 10d2. The second back side conductive pattern 74b may be a second back side source/drain contact plug.

The transistor region CA of the semiconductor device 1 may further include a first dummy conductive pattern 74d1 disposed below the buffer insulating layer 68 and vertically overlapping the first source/drain pattern 10c1, and a second dummy conductive pattern 74d2 disposed below the buffer insulating layer 68 and vertically overlapping the third source/drain pattern 10d1.

The first and second back side conductive patterns 74a and 74b and the first and second dummy conductive patterns 74d1 and 74d2 may have lower surfaces coplanar with each other.

In an example, lower surfaces of the first and second semiconductor bodies 5a and 5b may be disposed on a level lower than a level of a center between upper surfaces and lower surfaces of each of the first and second back side conductive patterns 74a and 74b.

At least a portion of each of the first and second back side conductive patterns 74a and 74b may be disposed at the same level as at least a portion of each of the first and second semiconductor bodies 5a and 5b.

The transistor region CA of the semiconductor device 1 may further include insulating separation structures 71 and an insulating layer 70. The insulating separation structures 71 may extend downwardly by penetrating through the first and second semiconductor layers 5c and 5d and the buffer insulating layer 68 disposed below the gate electrodes 32c and 32d, and the insulating layer 70 may be disposed on side surfaces of the insulating separation structures 71 below the buffer insulating layer 68. The first back side conductive pattern 74a and the first dummy conductive pattern 74d1 may be separated from each other by the insulating separation structure 71, and the second back side conductive pattern 74b and the second dummy conductive pattern 74d2 may be separated from each other by the insulating separation structure 71.

The transistor region CA of the semiconductor device 1 may further include back side interconnection structures 96a and 96b embedded in the back side insulating structure 92 and electrically connected to the first and second back side conductive patterns 74a and 74b.

The back side interconnection structures 96a and 96b may include a first back side interconnection structure 96a electrically connected to the first back side conductive pattern 74a and a second back side interconnection structure 96b electrically connected to the second back side conductive pattern 74b.

The first back side interconnection structure 96a may include a first-first back side interconnection structure 80a electrically connected to the first back side conductive pattern 74a and penetrating through the first back side etch stop layer 76 and the first back side interlayer insulating layer 78, a first-second back side interconnection structure 86a penetrating through the second back side etch stop layer 82 and the second back side interlayer insulating layer 84, and a first-third back side interconnection structure 94a penetrating through the third back side etch stop layer 88 and the third back side interlayer insulating layer 90. The second back side interconnection structure 96b may include a second-first back side interconnection structure 80b electrically connected to the second back side conductive pattern 74b and penetrating the first back side etch stop layer 76 and the first back side interlayer insulating layer 78, a second-second back side interconnection structure 86b penetrating through the second back side etch stop layer 82 and the second back side interlayer insulating layer 84, and a second-third back side interconnection structure 94b penetrating through the third back side etch stop layer 88 and the third back side interlayer insulating layer 90.

The connection region CA of the semiconductor device 1 may include a front input/output interconnection structure 55io, a back side input/output interconnection structure 96io, and a connection contact structure 79 electrically connecting the front input/output interconnection structure 55io and the back side input/output interconnection structure 96io between the front input/output interconnection structure 55io and the back side input/output interconnection structure 96io. The front input/output interconnection structure 55io may be disposed on the second interlayer insulating layer 49. The back side input/output interconnection structure 96io may be embedded in at least a portion of the back side insulating structure 92. For example, the back side input/output interconnection structure 96io may include a first back side input/output interconnection structure 86io penetrating through the second back side etch stop layer 82 and the second back side interlayer insulating layer 84, and a second back side input/output interconnection structure 94io penetrating through the third back side etch stop layer 88 and the third back side interlayer insulating layer 90. The connection contact structure 79 may penetrate through portions of the device isolation layer 25, the first and second interlayer insulating layers 43 and 49 and the back side insulating structure 92.

The back side interconnection structures 96a, 96b and 96io, the back side conductive patterns 74a and 74b, and the connection contact structure 79 may be used as paths for input/output signals, power voltages, and ground voltages.

Next, various modified examples of the elements of the above-described example implementation will be described. The various modified examples of the elements of the above-described example implementation will be described with a focus on the modified or replaced elements. Here, the elements described above may be directly cited without a separate detailed description, or the description thereof may be omitted. Additionally, the modified or replaced elements described below will be described with reference to the drawings below, but the modified or replaced elements may be combined with each other, or may be combined with the elements described above to form a semiconductor device.

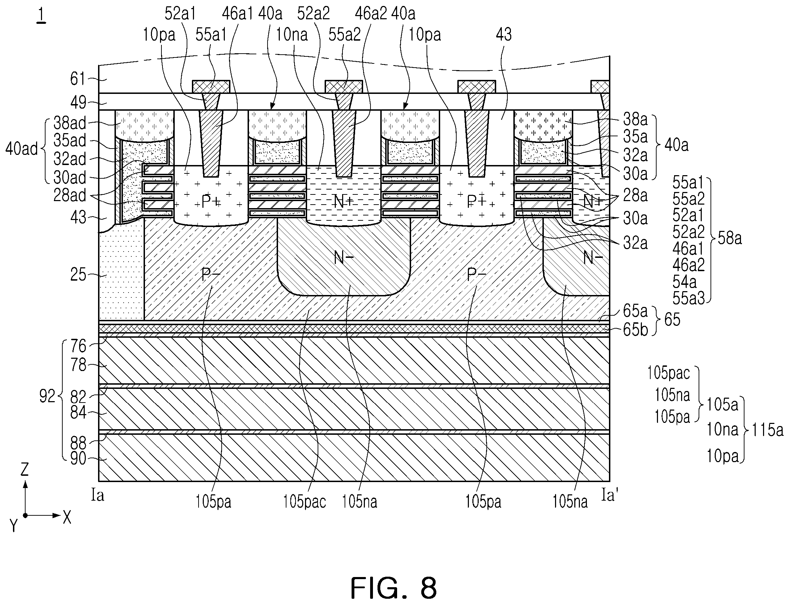

FIG. 8 is a cross-sectional view corresponding to a region taken along line Ia-Ia' of FIG. 2A to explain an example of a semiconductor device.

In an example, referring to FIG. 8, the first semiconductor body 5a (see FIG. 3A) including the first and second semiconductor regions Spa and 5na in FIG. 3A may be replaced with a first semiconductor body 105a as in FIG. 8. For example, the first semiconductor body 105a may include first semiconductor regions 105pa and second semiconductor regions 105na alternately arranged in the first direction (X-direction), and connection semiconductor regions 105pac extending below the second semiconductor regions 105na from lower regions of the first semiconductor regions 105pa. Accordingly, the first device 15a in FIG. 3A may be replaced with a first device 115a including the first and second semiconductor patterns 10pa and 10na along with the first semiconductor body 105a.

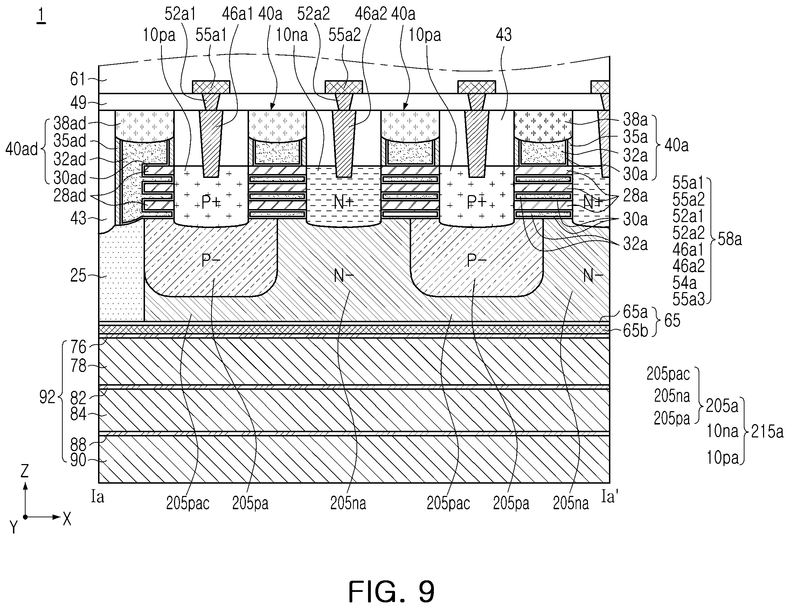

FIG. 9 is a cross-sectional view corresponding to a region taken along line Ia-Ia' of FIG. 2A to explain an example of a semiconductor device.

In an example, referring to FIG. 9, the first semiconductor body 5a (see FIG. 3A) including the first and second semiconductor regions Spa and 5na in FIG. 3A may be replaced with a first semiconductor body 205a as in FIG. 9. For example, the first semiconductor body 205a may include first semiconductor regions 205pa and second semiconductor regions 205na alternately arranged in the first direction (X-direction), and connection semiconductor regions 205pac extending below the first semiconductor regions 205pa from lower regions of the second semiconductor regions 205na. Accordingly, the first device 15a in FIG. 3A may be replaced with a first device 215a including the first and second semiconductor patterns 10pa and 10na along with the first semiconductor body 205a.

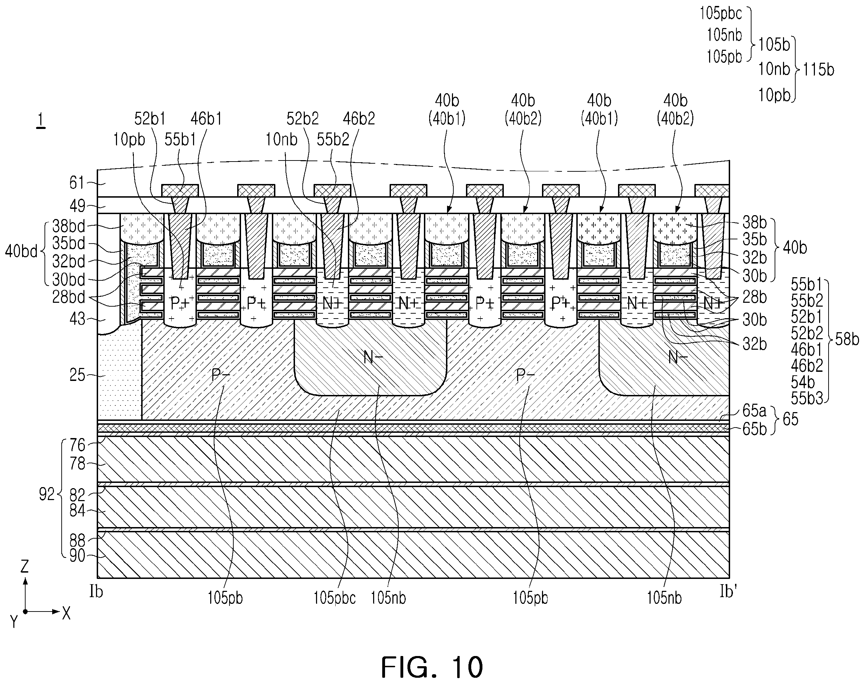

FIG. 10 is a cross-sectional view corresponding to a region taken along line Ib-Ib' of FIG. 4A to explain an example of a semiconductor device.

In an example, referring to FIG. 10, the second semiconductor body 5b (see FIG. 5A) including the third and fourth semiconductor regions 5pb and 5nb in FIG. 5A may be replaced with a second semiconductor body 105b as in FIG. 10. For example, the second semiconductor body 105b may include third semiconductor regions 105pb and fourth semiconductor regions 105nb alternately arranged in the first direction (X-direction), and connection semiconductor regions 105pbc extending below the fourth semiconductor regions 105nb from lower regions of the third semiconductor regions 105pb. Accordingly, the second device 15b in FIG. 5A may be replaced with a second device 115b including the third and fourth semiconductor patterns 10pb and 10nb along with the second semiconductor body 105b.

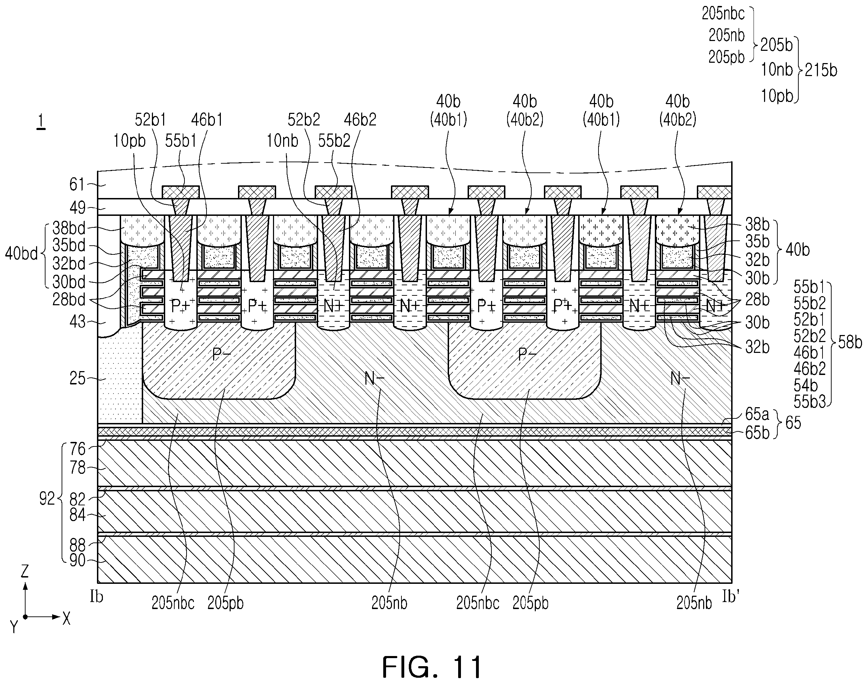

FIG. 11 is a cross-sectional view corresponding to a region taken along line Ib-Ib' of FIG. 4A to explain an example of a semiconductor device.

In an example, referring to FIG. 11, the second semiconductor body 5b (see FIG. 5A) including the third and fourth semiconductor regions 5pb and 5nb in FIG. 5A may be replaced with a second semiconductor body 205b as in FIG. 11. For example, the second semiconductor body 205b may include third semiconductor regions 205pb and fourth semiconductor regions 205nb alternately arranged in the first direction (X-direction), and connection semiconductor regions 205nbc extending below the third semiconductor regions 205pb from lower regions of the fourth semiconductor regions 205nb. Accordingly, the second device 15b in FIG. 5A may be replaced with a second device 215b including the third and fourth semiconductor patterns 10pb and 10nb along with the second semiconductor body 205b.

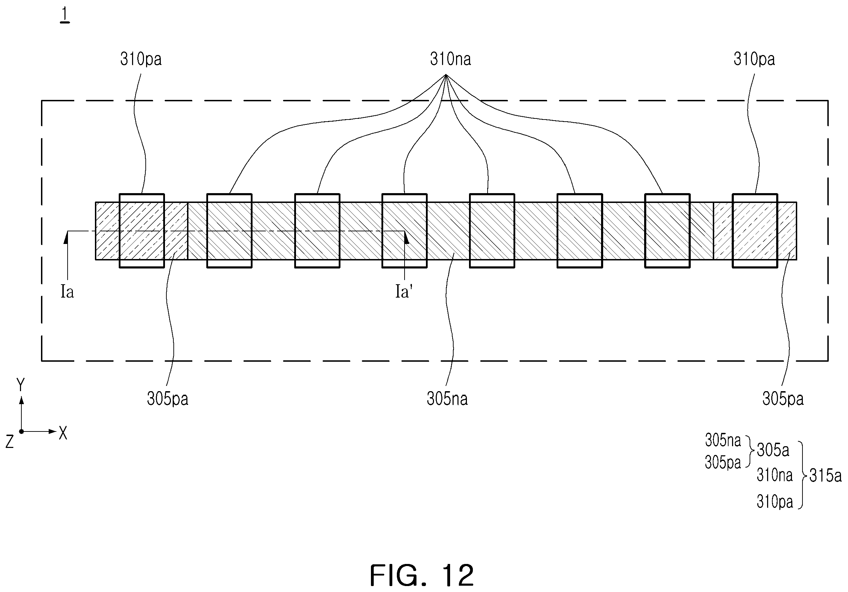

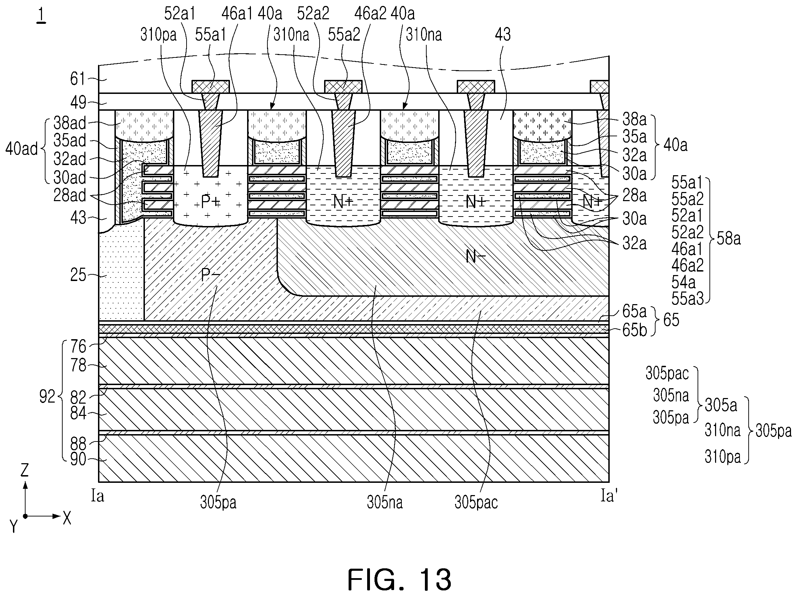

FIG. 12 and FIG. 13 are explanatory views illustrating an example of a semiconductor device, and FIG. 12 is a plan view illustrating a region corresponding to FIG. 2B, and FIG. 13 illustrates a region taken along line Ia-Ia' of FIG. 12, and is a cross-sectional view corresponding to a region taken along line Ia-Ia' of FIG. 2B.

In an example, referring to FIGS. 12 and 13, the first semiconductor body 5a (see FIG. 3A) including the first and second semiconductor regions Spa and 5na in FIGS. 2A, 2B and 3A may be replaced with a first semiconductor body 305a as in FIGS. 12 and 13. For example, the first semiconductor body 305a may include a second semiconductor region 305na having a shape extending in the first direction (X-direction), first semiconductor regions 305pa disposed on both sides of the second semiconductor region 305na in the first direction (X-direction), and a connection semiconductor region 305pac extending below the second semiconductor region 305na from lower regions of the first semiconductor regions 305pa. The first and second semiconductor patterns 10pa and 10na in FIG. 2A, FIG. 2B and FIG. 3A may be replaced with first semiconductor patterns 310pa disposed on the first semiconductor regions 305pa and second semiconductor patterns 310na disposed on the second semiconductor region 305na. Accordingly, the first device 15a in FIG. 3A may be replaced with a first device 315a including the first and second semiconductor patterns 310pa and 310na along with the first semiconductor body 305a.

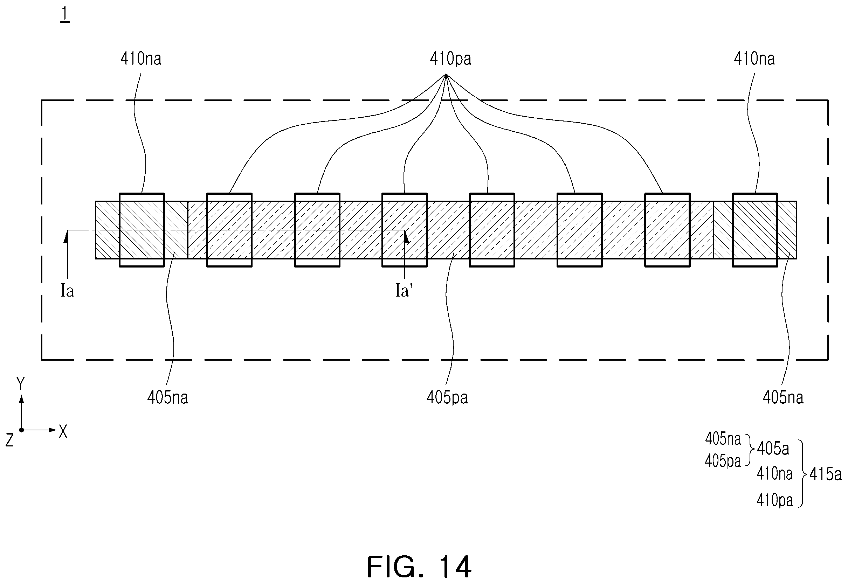

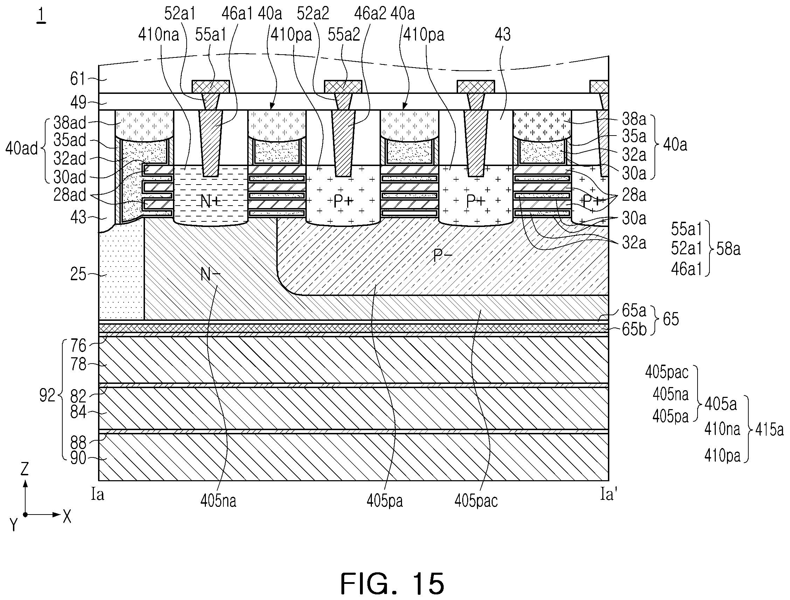

FIGS. 14 and 15 are explanatory views illustrating an example of a semiconductor device, and FIG. 14 is a plan view illustrating a region corresponding to FIG. 2B, and FIG. 15 illustrates a region taken along line Ia-Ia' of FIG. 14, and is a cross-sectional view corresponding to a region taken along line Ia-Ia' of FIG. 2B.

In an example, referring to FIGS. 14 and 15, the first semiconductor body 5a (see FIG. 3A) including the first and second semiconductor regions Spa and 5na in FIGS. 2A, 2B and 3A may be replaced with a first semiconductor body 405a as in FIGS. 14 and 15. For example, the first semiconductor body 405a may include a first semiconductor region 405pa having a shape extending in the first direction (X-direction), second semiconductor regions 405na disposed on both sides of the first semiconductor region 405pa in the first direction (X-direction), and a connection semiconductor region 405pac extending below the first semiconductor region 405pa from lower regions of the second semiconductor regions 405na. The first and second semiconductor patterns 10pa and 10na in FIGS. 2A, 2B and 3A may be replaced with first semiconductor patterns 410pa disposed on the first semiconductor region 405pa and second semiconductor patterns 410na disposed on the second semiconductor regions 405na. Accordingly, the first device 15a in FIG. 3A may be replaced with a first device 415a including the first and second semiconductor patterns 410pa and 410na along with the first semiconductor body 405a.

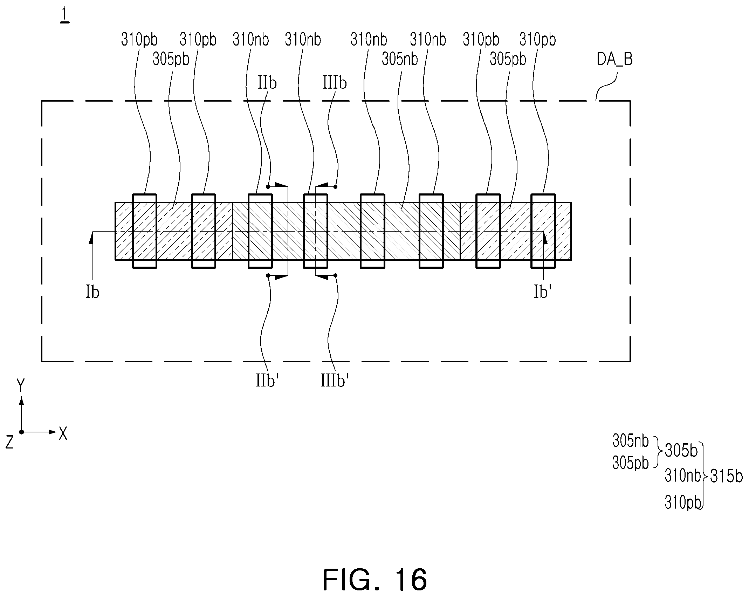

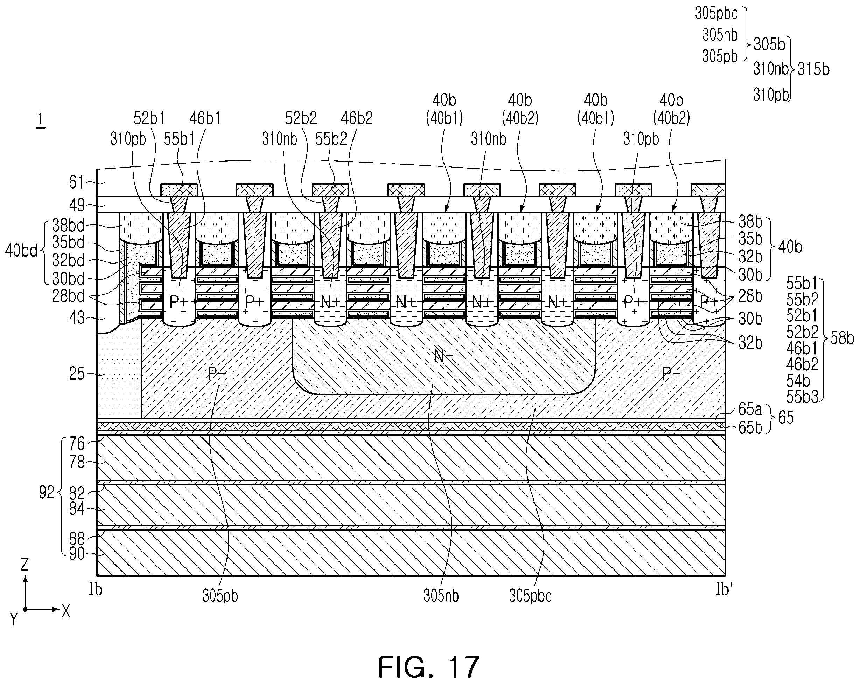

FIG. 16 and FIG. 17 are explanatory views illustrating an example of a semiconductor device, and FIG. 16 is a plan view illustrating a region corresponding to FIG. 4B, while FIG. 17 illustrates a region taken along line Ib-Ib' of FIG. 16, and is a cross-sectional view corresponding to a region taken along line Ib-Ib' of FIG. 4B.

In an example, referring to FIGS. 16 and 17, the second semiconductor body 5b (see FIG. 5A) including the third and fourth semiconductor regions 5pb and 5nb in FIGS. 4A, 4B and 5A may be replaced with a second semiconductor body 305b as in FIGS. 16 and 17. For example, the second semiconductor body 305b may include a fourth semiconductor region 305nb having a shape extending in the first direction (X-direction), third semiconductor regions 305pb disposed on both sides of the fourth semiconductor region 305nb in the first direction (X-direction), and a connection semiconductor region 305pbc extending below the fourth semiconductor region 305nb from lower regions of the third semiconductor regions 305pb. The third and fourth semiconductor patterns 10pb and 10nb in FIG. 4A, FIG. 4B and FIG. 5A may be replaced with third semiconductor patterns 310pb disposed on the third semiconductor regions 305pb and fourth semiconductor patterns 310nb disposed on the fourth semiconductor region 305nb. Accordingly, the second device 15b in FIG. 5A may be replaced with a second device 315b including the third and fourth semiconductor patterns 310pb and 310nb along with the second semiconductor body 305b.

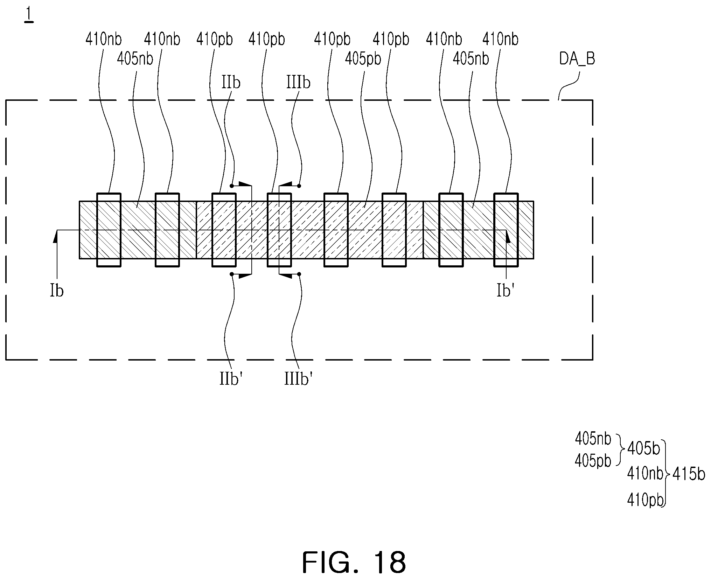

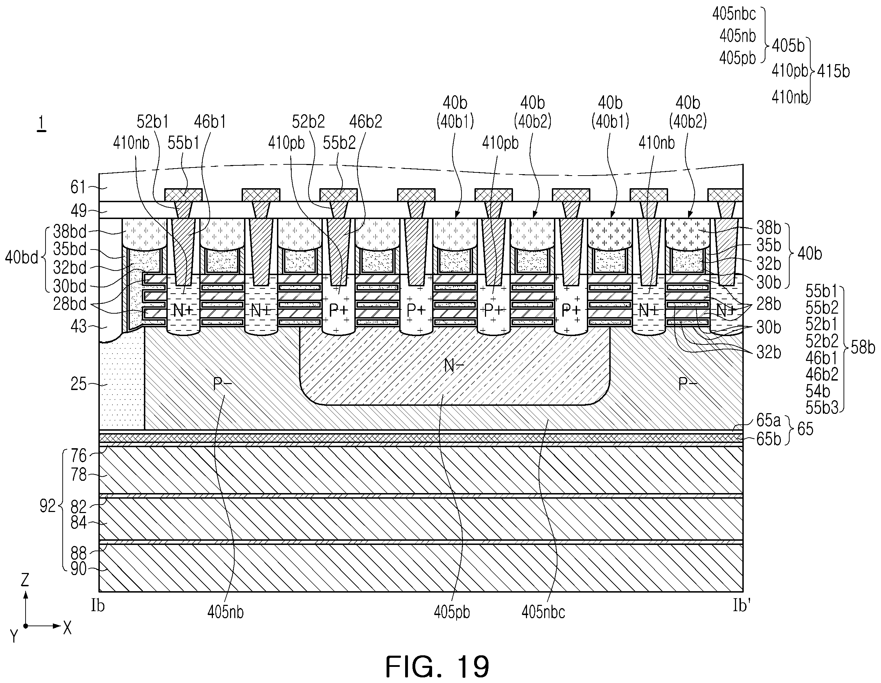

FIGS. 18 and 19 are explanatory views illustrating an example of a semiconductor device, and FIG. 18 is a plan view illustrating a region corresponding to FIG. 4B, and FIG. 19 illustrates a region taken along line Ib-Ib' of FIG. 18, and is a cross-sectional view corresponding to a region taken along line Ib-Ib' of FIG. 4B.

In an example, referring to FIGS. 18 and 19, the second semiconductor body 5b (see FIG. 5A) including the third and fourth semiconductor regions 5pb and 5nb in FIGS. 4A, 4B and 5A may be replaced with a second semiconductor body 405b as in FIGS. 18 and 19. For example, the second semiconductor body 405b may include a third semiconductor region 405pb having a shape extending in the first direction (X-direction), fourth semiconductor regions 405nb disposed on both sides of the third semiconductor region 405pb in the first direction (X-direction), and a connection semiconductor region 405nbc extending below the third semiconductor region 405pb from lower regions of the fourth semiconductor regions 405nb. The third and fourth semiconductor patterns 10pb and 10nb in FIGS. 4A, 4B and 5A may be replaced with third semiconductor patterns 410pb disposed on the third semiconductor region 405pb and fourth semiconductor patterns 410nb disposed on the fourth semiconductor regions 405nb. Accordingly, the second device 15b in FIG. 5A may be replaced with a second device 415b including the third and fourth semiconductor patterns 410pb and 410nb along with the second semiconductor body 405b.

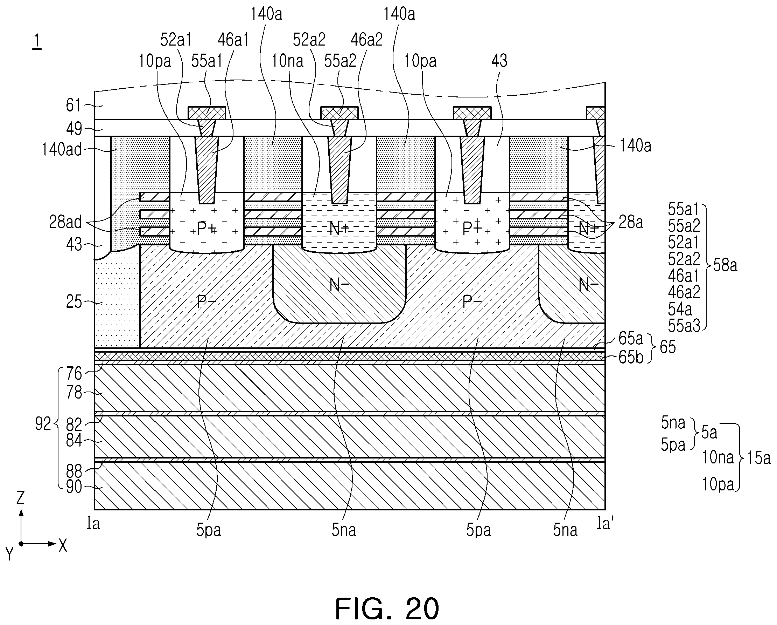

FIG. 20 is a cross-sectional view corresponding to a region taken along the line Ia-Ia' of FIG. 2A to explain an example of a semiconductor device.

In an example, referring to FIG. 20, gate structures 40ad and 40a in FIGS. 3A and 3B may be replaced with insulating structures 140ad and 140a. The insulating structures 140ad and 140a may not include a conductive material of the gate electrode. The insulating structures 140ad and 140a may be formed of an insulating material such as silicon oxide or silicon nitride.

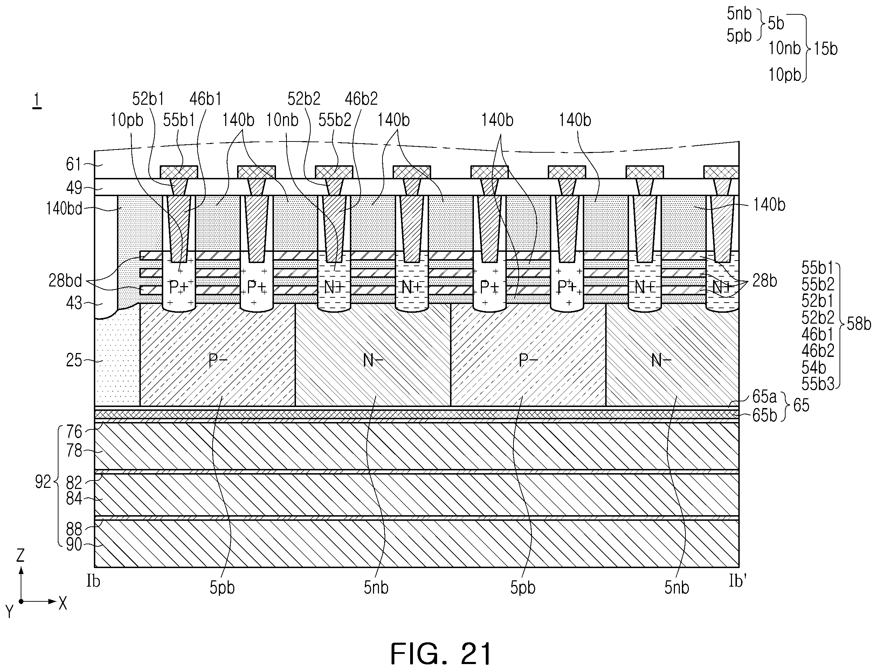

FIG. 21 is a cross-sectional view corresponding to a region taken along line Ib-Ib' of FIG. 4A to explain an example of a semiconductor device.

In an example, referring to FIG. 21, the gate structures 40bd and 40b in FIGS. 5A and 5B may be replaced with insulating structures 140bd and 140b. The insulating structures 140bd and 140b may not include a conductive material of the gate electrode. The insulating structures 140bd and 140b may be formed of an insulating material such as silicon oxide or silicon nitride.

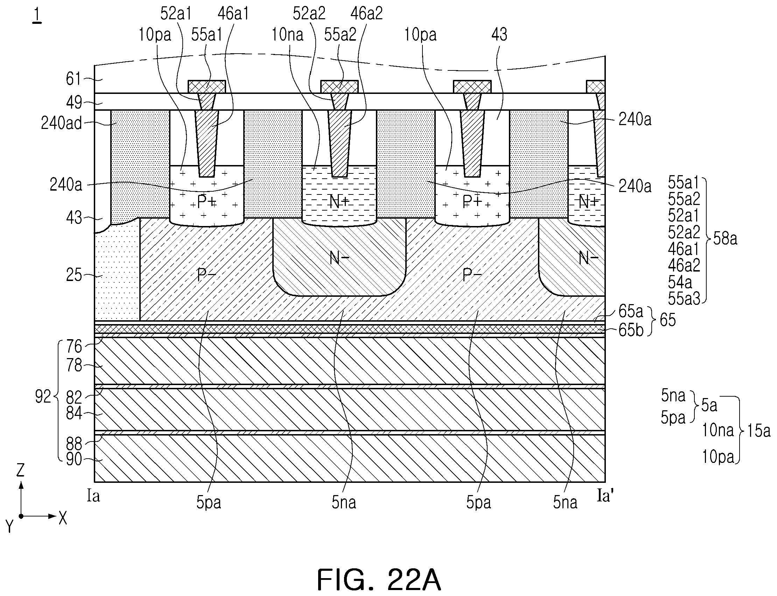

FIG. 22A is a cross-sectional view corresponding to a region taken along line Ia-Ia' of FIG. 2A to illustrate an example of a semiconductor device.

In an example, referring to FIG. 22A, the gate structures 40ad and 40a and the dummy active structures 28ad and 28a in FIGS. 3A and 3B may be replaced with insulating structures 240ad and 240a. The insulating structures 240ad and 240a may not include a conductive material of the gate electrode and a semiconductor material of the active layers. The insulating structures 240ad and 240a may be formed of an insulating material such as silicon oxide or silicon nitride.

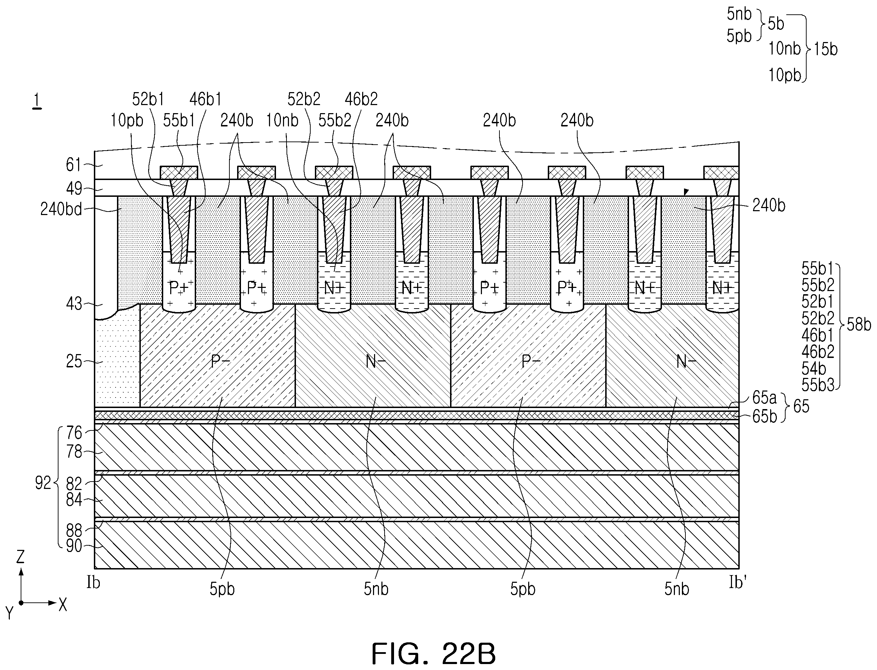

FIG. 22B is a cross-sectional view corresponding to a region taken along line Ib-Ib' of FIG. 4A to explain an example of a semiconductor device,

In an example, referring to FIG. 22B, the gate structures 40bd and 40b and the dummy active structures 28bd and 28b in FIGS. 5A and 5B may be replaced with insulating structures 240bd and 240b. The insulating structures 240bd and 240b may not include a conductive material of the gate electrode and a semiconductor material of the active layers. The insulating structures 240bd and 240b may be formed of an insulating material such as silicon oxide or silicon nitride.

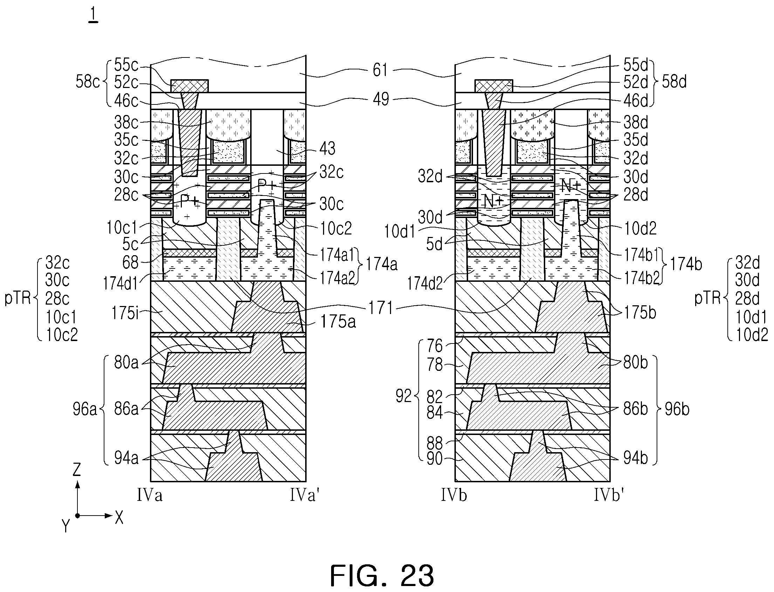

FIG. 23 is a cross-sectional view corresponding to areas taken along lines IVa-Iva' and IVb-IVb' of FIG. 6 to explain an example of a semiconductor device, and may illustrate a modified portion in the cross-sectional structure of FIG. 7A.

In an example, referring to FIG. 23, the first and second back side conductive patterns 74a and 74b and the first and second dummy conductive patterns 74d1 and 74d2 described in FIG. 7A may be replaced with first and second back side conductive patterns 174a and 174b and first and second dummy conductive patterns 174d1 and 174d2 having a reduced thickness, and the insulating separation structure 71 may be replaced with the insulating separation structure 171 having a reduced thickness. For example, lower surfaces of the first and second back side conductive patterns 174a and 174b, the first and second dummy conductive patterns 174d1 and 174d2 and the insulating separation structure 171 may be disposed on a higher level than a level of lower surfaces of the first and second semiconductor bodies 5a and 5b (see FIG. 3A and FIG. 5B).

The first back side conductive pattern 174a may include a first portion 174a2 disposed below the buffer insulating layer 68, and a second portion 174a1 extending upwardly from the first portion 174a2 to penetrate through the buffer insulating layer 68 and the first semiconductor layer 5c and electrically connected to the second source/drain pattern 10c2. The second back side conductive pattern 174b may include a first portion 174b2 disposed below the buffer insulating layer 68, and a second portion 174b 1 extending upwardly from the first portion 174b2 to penetrate through the buffer insulating layer 68 and the second semiconductor layer 5d and electrically connected to the fourth source/drain pattern 10d2.

The transistor region CA of the semiconductor device 1 may further include a first connection interconnection structure 175a electrically connecting the first back side interconnection structure 96a and the first back side conductive pattern 174a between the first back side interconnection structure 96a and the first back side conductive pattern 174a, and a second connection interconnection structure 175b electrically connecting the second back side interconnection structure 96b and the second back side conductive pattern 174b between the second back side interconnection structure 96b and the second back side conductive pattern 174b.

A center between upper surfaces and lower surfaces of each of the first and second connection interconnection structures 175a and 175b may be disposed on a level higher than a level of the lower surfaces of the first and second semiconductor bodies 5a and 5b (see FIG. 3A and FIG. 5A).

The transistor region CA of the semiconductor device 1 may further include an intermediate insulating layer 175i surrounding side surfaces of the first and second connection interconnection structures 175a and 175b. An upper surface of the back side insulating structure 92 may be in contact with a lower surface of the intermediate insulating layer 175i.

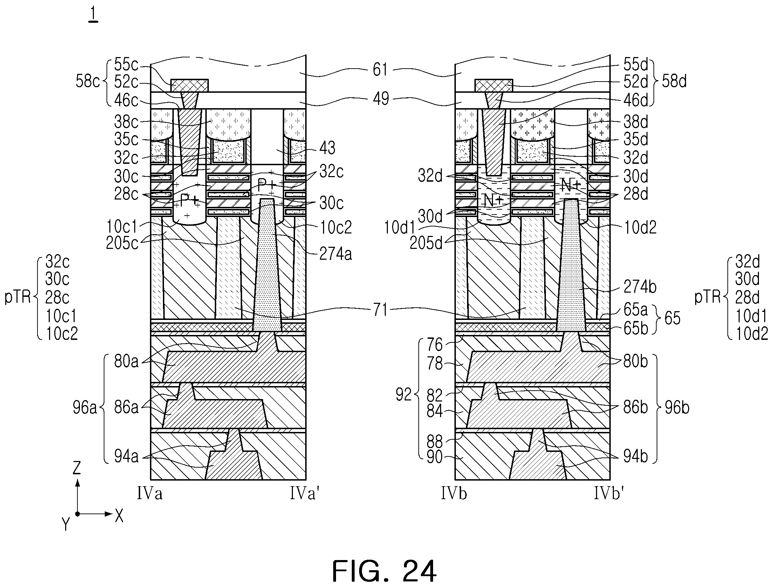

FIG. 24 is a cross-sectional view corresponding to regions taken along lines IVa-IVa' and IVb-IVb' of FIG. 6 to explain an example of a semiconductor device, and may illustrate a modified portion in a cross-sectional structure of FIG. 7A.

In an example, referring to FIG. 24, the buffer insulating layer 68 described in FIG. 7A may be omitted, and the first and second semiconductor layers 5c and 5d described in FIG. 7A may be replaced with first and second semiconductor layers 205c and 205d disposed at the same level as the first and second semiconductor bodies 5a and 5b (see FIG. 3A and FIG. 5B) and having the same thickness as the first and second semiconductor bodies 5a and 5b (see FIG. 3A and FIG. 5B). The insulating separation structure 71 may penetrate through the first and second semiconductor layers 205c and 205d in the vertical direction (Z-direction). The dummy conductive patterns 74d1 and 74d2 (see FIG. 7A) described in FIG. 7A may be omitted, and the first back side conductive pattern 74a (see FIG. 7A) described in FIG. 7A may be replaced with a first back side conductive pattern 274a penetrating the first semiconductor layer 205c and electrically connected to the second source/drain pattern 10c2, and the second back side conductive pattern 74b (see FIG. 7A) described in FIG. 7A may be replaced with a second back side conductive pattern 274b penetrating through the second semiconductor layer 205d and electrically connected to the fourth source/drain pattern 10d2.

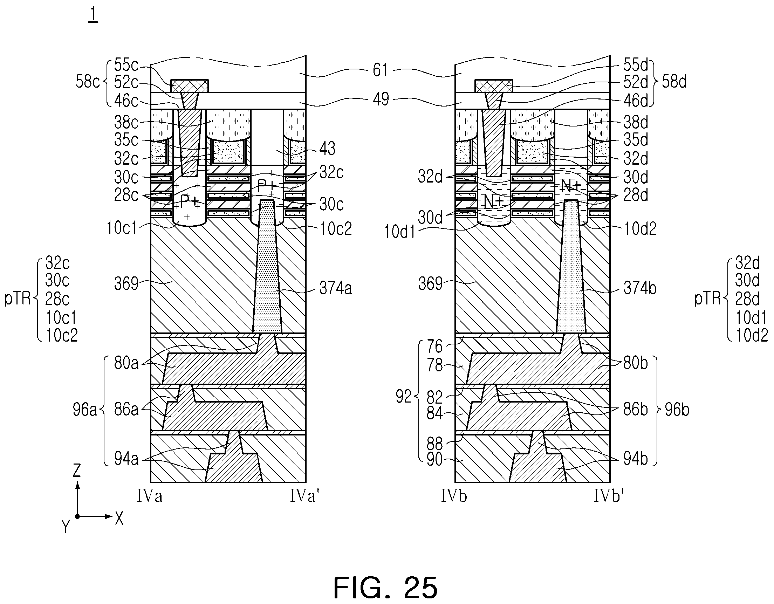

FIG. 25 is a cross-sectional view corresponding to regions taken along lines IVa-IVa' and IVb-IVb' of FIG. 6 to explain an example of a semiconductor device, and may illustrate a modified portion of the cross-sectional structure of FIG. 24.

In an example, referring to FIG. 25, the first and second semiconductor layers 205c and 205d (see FIG. 24) and the insulating separation structure 71 (see FIG. 24) described in FIG. 24 may be replaced with an insulating structure 369. The insulating structure 369 may be disposed between the first and second transistors pTR and nTR and the back side insulating structure 92. The first back side conductive pattern 274a (see FIG. 24) described in FIG. 24 may be replaced with a first back side conductive pattern 374a penetrating through the insulating structure 369 and electrically connected to the second source/drain pattern 10c2, and the second back side conductive pattern 274b (see FIG. 24) described in FIG. 24 may be replaced with a second back side conductive pattern 374b penetrating the insulating structure 369 and electrically connected to the fourth source/drain pattern 10d2.

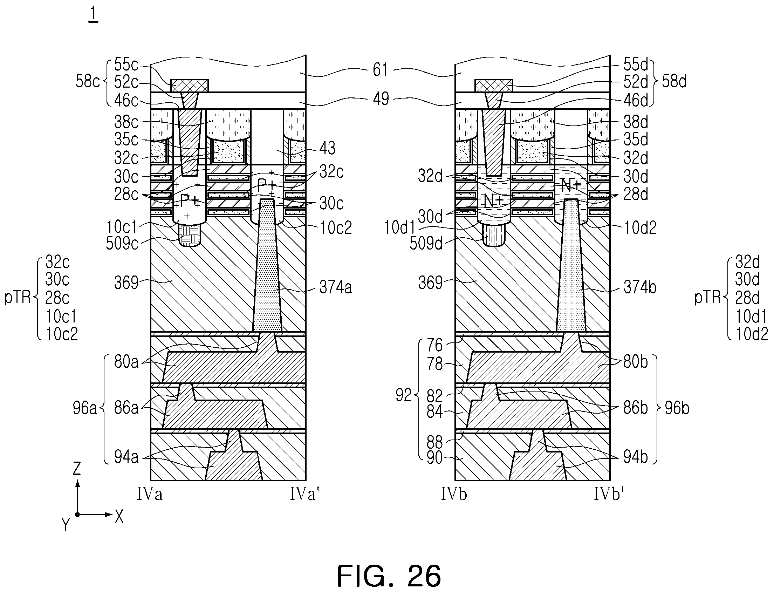

FIG. 26 is a cross-sectional view corresponding to regions taken along lines IVa-IVa' and IVb-IVb' of FIG. 6 to explain an example of a semiconductor device, and may illustrate a modified portion of the cross-sectional structure of FIG. 25.

In an example, referring to FIG. 26, the transistor region CA of the semiconductor device 1 may further include a first buffer semiconductor pattern 509c in contact with the first source/drain pattern 10c1 below the first source/drain pattern 10c1, and may further include a second buffer semiconductor pattern 509d in contact with the third source/drain pattern 10d1 below the third source/drain pattern 10d1. The first and second buffer semiconductor patterns 509c and 509d may include an epitaxial semiconductor material, for example, at least one of epitaxial germanium and epitaxial silicon germanium. Lower surfaces and side surfaces of each of the first and second buffer semiconductor patterns 509c and 509d may be in contact with the insulating structure 369.

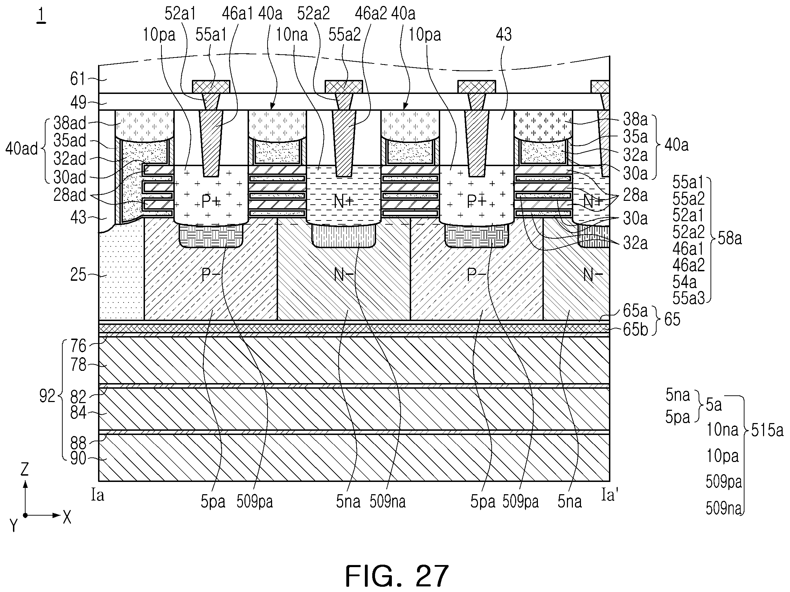

FIG. 27 is a cross-sectional view corresponding to a region taken along line Ia-Ia' of FIG. 2A to explain an example of a semiconductor device, and may illustrate a modified portion from the cross-sectional structure of FIG. 3A.

In an example, referring to FIG. 27, the first device 15a described above may be replaced with a first device 515a further including first buffer semiconductor patterns 509pa between the first semiconductor patterns 10pa and the first semiconductor regions 5pa and second buffer semiconductor patterns 509na between the second semiconductor patterns 10na and the second semiconductor regions 5na. The first buffer semiconductor patterns 509pa may have the same conductivity type as a conductivity type of the first semiconductor patterns 10pa and the first semiconductor regions 5pa. The second buffer semiconductor patterns 509na may have the same conductivity type as a conductivity type of the second semiconductor patterns 10na and the second semiconductor regions 5na. The first and second buffer semiconductor patterns 509pa and 509na above may include an epitaxial semiconductor material, for example, at least one of epitaxial germanium and epitaxial silicon germanium.

The first and second buffer semiconductor patterns 509pa and 509na may be equally disposed below lower surfaces of the first and second semiconductor patterns 10pa and 10na in FIG. 8, FIG. 9, FIG. 20 and FIG. 22A, lower surfaces of the first and second semiconductor patterns 310pa and 310na in FIG. 13, and lower surfaces of the first and second semiconductor patterns 410pa and 410na in FIG. 15.

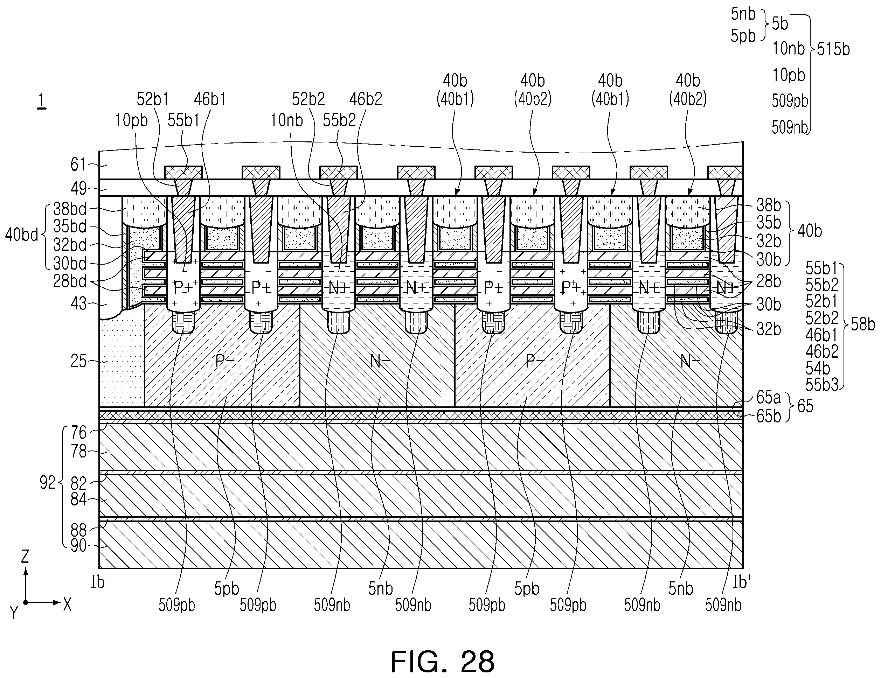

FIG. 28 is a cross-sectional view corresponding to a region taken along line Ib-Ib' of FIG. 4A to explain an example of a semiconductor device, and may illustrate a modified portion of the cross-sectional structure of FIG. 5A

In an example, referring to FIG. 28, the second device 15b described above may be replaced with a second device 515b further including third buffer semiconductor patterns 509pb between the third semiconductor patterns 10pb and the third semiconductor regions 5pb and fourth buffer semiconductor patterns 509nb between the fourth semiconductor patterns 10nb and the fourth semiconductor regions 5nb. The third buffer semiconductor patterns 509pb may have the same conductivity type as a conductivity type of the third semiconductor patterns 10pb and the third semiconductor regions 5pb. The fourth buffer semiconductor patterns 509nb may have the same conductivity type as a conductivity type of the fourth semiconductor patterns 10nb and the fourth semiconductor regions 5nb. The third and fourth buffer semiconductor patterns 509pb and 509nb may include an epitaxial semiconductor material, for example, at least one of epitaxial germanium and epitaxial silicon germanium.

The third and fourth buffer semiconductor patterns 509pb and 509nb described above may be equally disposed below lower surfaces of the third and fourth semiconductor patterns 10pb and 10nb in FIG. 5A, FIG. 10, FIG. 11, FIG. 21 and FIG. 22B, lower surfaces of the third and fourth semiconductor patterns 310pb and 310nb in FIG. 17, and lower surfaces of the third and fourth semiconductor patterns 410pb and 410nb in FIG. 19.

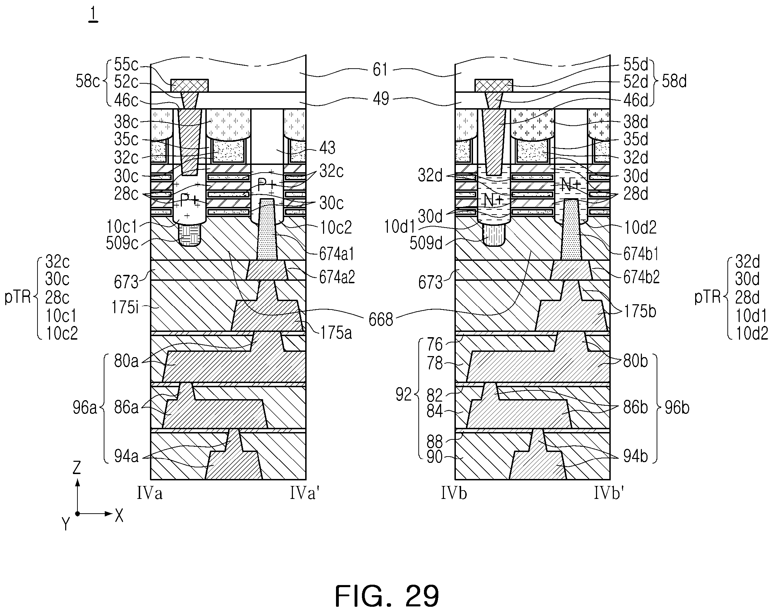

FIG. 29 is a cross-sectional view corresponding to regions taken along lines IVa-IVa' and IVb-IVb' of FIG. 6 to explain an example of a semiconductor device, and may illustrate a modified portion in the cross-sectional structure of FIG. 26.

In an example, referring to FIG. 29, the first back side conductive pattern 374a (see FIG. 26) described above may be replaced with a plurality of first back side conductive patterns 674a1, 674a2 and 175a, and the second back side conductive pattern 374b (see FIG. 26) described above may be replaced with a plurality of second back side conductive patterns 674b1, 674b2 and 175b.

The plurality of first back side conductive patterns 674a1, 674a2 and 175a may include a first-first back side conductive pattern 674a1 connected to the second source/drain pattern 10c2, a first-second back side conductive pattern 674a2 below the first-first back side conductive pattern 674a1, and a first-third back side conductive pattern 175a below the first-second back side conductive pattern 674a2. The plurality of second back side conductive patterns 674b1, 674b2 and 175b may include a second-first back side conductive pattern 674b1 connected to the fourth source/drain pattern 10d2, a second-second back side conductive pattern 674b2 below the second-first back side conductive pattern 674b1, and a second-third back side conductive pattern 175b below the second-second back side conductive pattern 674b2.

The insulating structure 369 (see FIG. 26) described above may be replaced with a first insulating layer 668 surrounding side surfaces of the first-first back side conductive pattern 674a1 and the second-first back side conductive pattern 674b1, a second insulating layer 673 surrounding side surfaces of the first-second back side conductive pattern 674a2 and the second-second back side conductive pattern 674b2, and a third insulating layer 175i surrounding side surfaces of the first-third back side conductive pattern 175a and the second-third back side conductive pattern 175b.

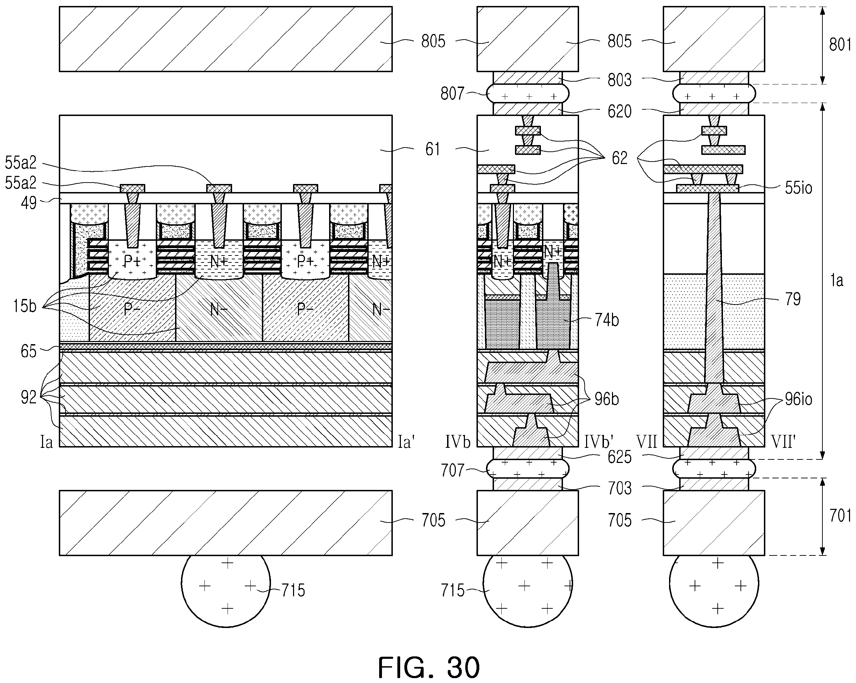

FIG. 30 is a cross-sectional view illustrating an example of a semiconductor device.

In an example, referring to FIG. 30, a semiconductor device 901 in an example may include a lower base 701, a semiconductor chip 1a disposed on the lower base 701, and an upper chip 801 on the semiconductor chip 1a.

The lower base 701 may be a buffer chip, a logic chip, a control chip, a memory chip, an interposer, a redistribution board, or a printed circuit board. The lower base 701 may include a body portion 705, pads 703 on the body portion 705, and bumps 715 below the body portion 705. The body portion 705 may include a circuit, a redistribution wiring, and/or a through interconnection structure.

The semiconductor chip 1a may include any one of the semiconductor devices 1 in example implementations described in FIGS. 1 to 29. In FIG. 30, the semiconductor chip 1a is illustrated as including, as an example, the Ia-Ia' cross-sectional structure of FIG. 3A, the IVb-IVb' cross-sectional structure of FIG. 7A, and the VII-VII' cross-sectional structure of FIG. 7B, but the semiconductor chip 1a may include any one of the example implementations described in FIGS. 1 to 29 that are not illustrated in FIG. 30.

The semiconductor chip 1a may include lower pads 625 below the back side interconnection structures 96a (see FIG. 7A), and the back side interconnection structures 96b and 96io (see FIG. 30), upper front interconnection structures 62 in the front insulating structure 61, and upper pads 620 on the upper front interconnection structures 62.

The upper chip 801 may be a control chip, a logic chip, or a memory chip. The upper chip 801 may include a body portion 805 including a circuit and pads 803 below the body portion 805.

The semiconductor device 901 may further include conductive bumps 707 connecting the pads 703 of the lower base 701 and the lower pads 625 of the semiconductor chip 1a, and conductive bumps 807 connecting the upper pads 620 of the semiconductor chip 1a and the pads 803 of the upper chip 801.

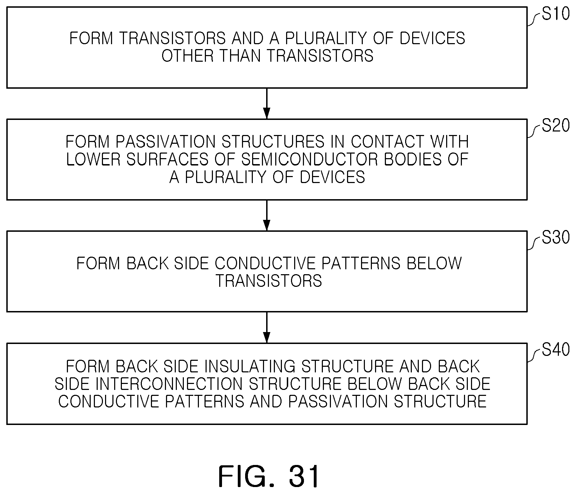

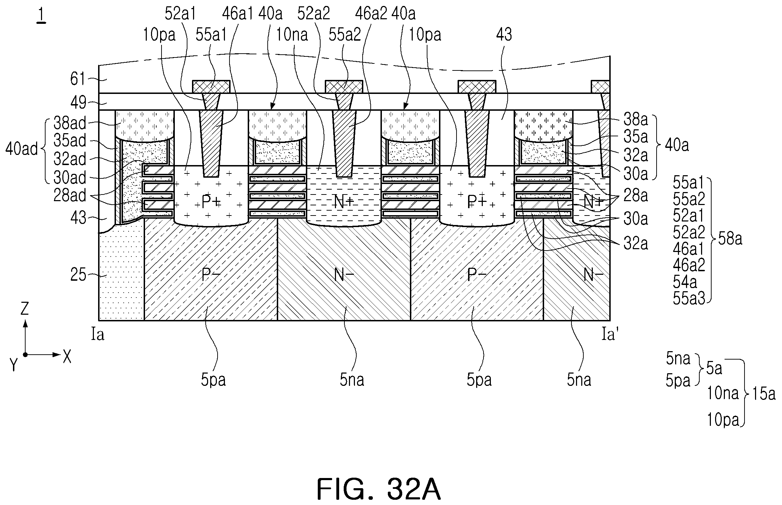

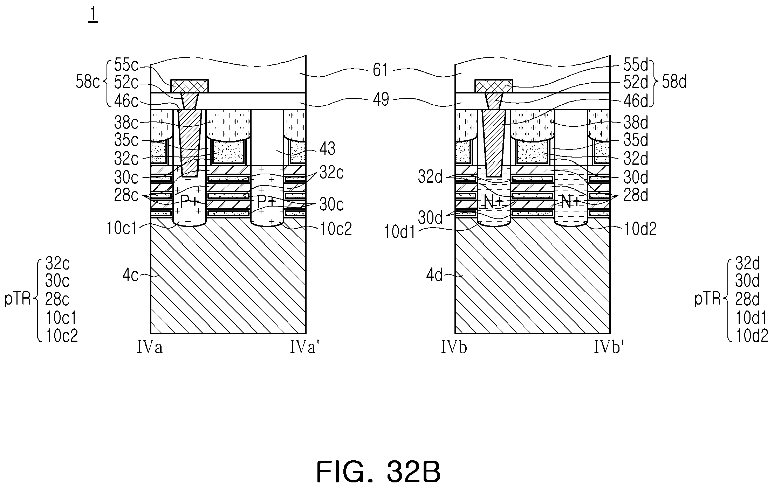

Next, with reference to FIGS. 31 and 32A to 34B, an example of a method for forming a semiconductor device will be described. In FIG. 31, FIG. 32A to FIG. 34B, FIG. 31 is a process flow diagram for explaining a semiconductor device forming method, FIG. 32A, FIG. 33A and FIG. 34A are cross-sectional views illustrating a region taken along line Ia-Ia' of FIG. 2A to explain a semiconductor device forming method, and FIG. 32B, FIG. 33B and FIG. 34B are cross-sectional views illustrating a region taken along line IVa-IVa' and line IVb-IVb' of FIG. 6 to explain a semiconductor device forming method.

Referring to FIG. 31, FIG. 32A and FIG. 32B, transistors pTR and nTR and a plurality of devices 15a and 15b (see FIG. 5A) other than the transistors pTR and nTR may be formed. The transistors pTR and nTR may be the first and second transistors pTR and nTR described in FIGS. 6, 7A and 7B, and the plurality of devices 15a and 15b (see FIG. 5A) may include the first device 15a described in FIGS. 2A to 3B and the second device 15b described in FIGS. 3A to 5B. Next, a semiconductor process may be performed to form a structure until the front insulating structure 61 of FIGS. 2A to 7B and the upper front interconnection structures 62 of FIG. 30. Then, a process of reducing a thickness of the semiconductor wafer may be performed to expose the lower surface of the first semiconductor body 5a of the first device 15a and the lower surface of the second semiconductor body 5b (see FIG. 5A) of the second device 15b (see FIG. 5A). Here, remaining semiconductor layers 4c and 4d may be formed below the first and second transistors pTR and nTR. Lower surfaces of the semiconductor layers 4c and 4d may be coplanar with the lower surface of the first semiconductor body 5a of the first device 15a and the lower surface of the second semiconductor body 5b (See FIG. 5A) of the second device 15b (see FIG. 5A).

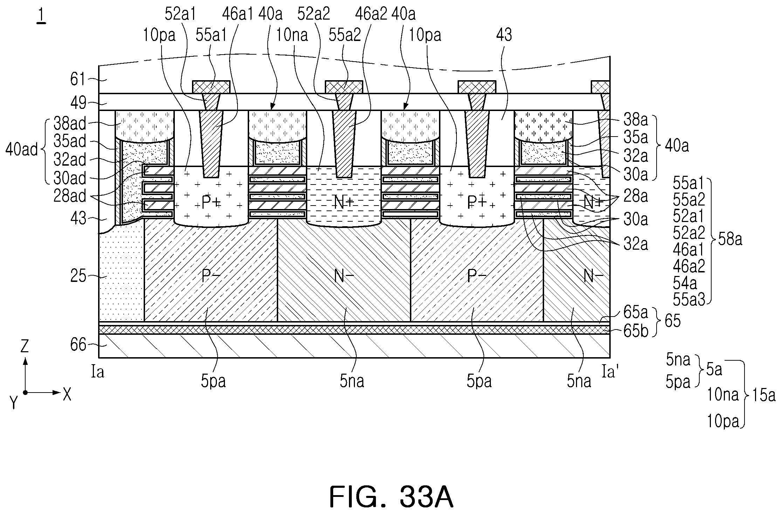

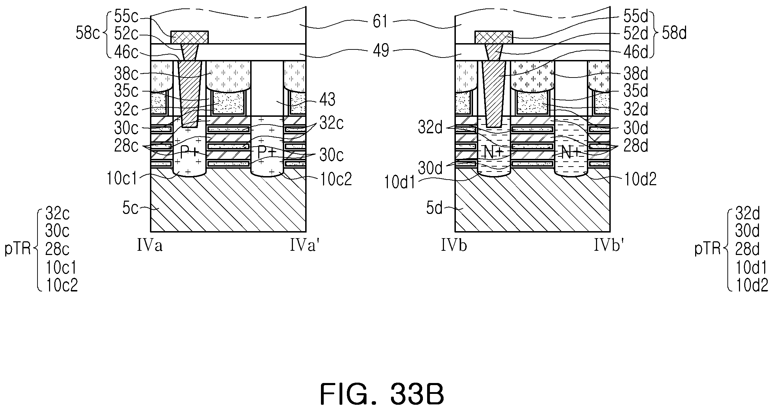

Referring to FIG. 31, FIG. 33A and FIG. 33B, a passivation structure 65 in contact with the lower surfaces of the semiconductor layers 4c and 4d (see FIG. 32B), the lower surface of the first semiconductor body 5a of the first device 15a and the lower surface of the second semiconductor body 5b (see FIG. 5A) of the second device 15b (see FIG. 5A) may be formed.

Forming the passivation structure 65 may include forming a first passivation layer 65a in contact with the lower surfaces of the semiconductor layers 4c and 4d (see FIG. 32B), the lower surface of the first semiconductor body 5a of the first device 15a, and the lower surface of the second semiconductor body 5b (see FIG. 5A) of the second device15b (see FIG. 5A), and forming a second passivation layer 65b in contact with the first passivation layer 65a.

The first passivation layer 65a may be formed as an oxide layer capable of reducing surface defects, such as dangling bonds, on the lower surface of the first semiconductor body 5a of the first device 15a and the lower surface of the second semiconductor body 5b (see FIG. 5A) of the second device 15b (see FIG. 5A). The first passivation layer 65a may be formed as a high-κ dielectric layer capable of reducing surface defects on the lower surface of the first semiconductor body 5a of the first device 15a and the lower surface of the second semiconductor body 5b (see FIG. 5A) of the second device 15b (see FIG. 5A) using fixed charges.

A mask pattern 66 exposing the passivation structure 65 of the transistor region CA, and covering the passivation structure 65 of the first and second device regions DA_A and DA_B may be formed.

Then, an etching process using the mask pattern 66 as an etching mask may be performed, the passivation structure 65 of the transistor region CA may be etched and removed, and the semiconductor layers 4c and 4d (see FIG. 32B) may be partially etched, thus forming the first and second semiconductor layers 5c and 5d having a reduced thickness. According to some implementations, the semiconductor layers 4c and 4d (see FIG. 32B) may be completely etched and removed.

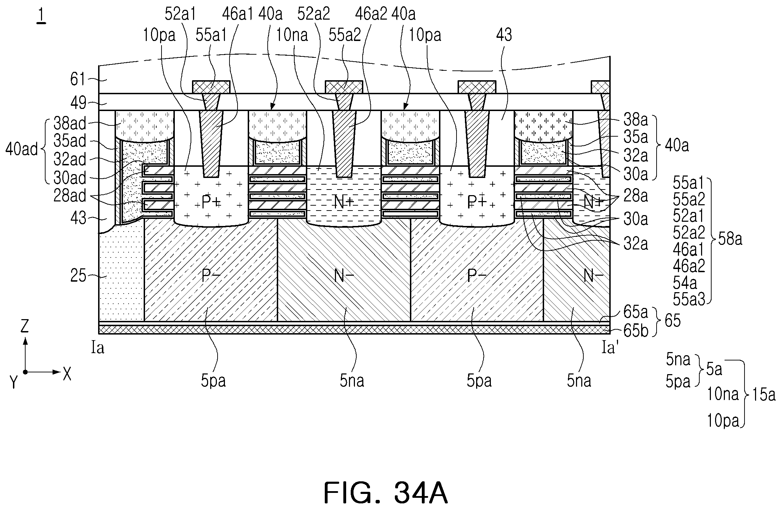

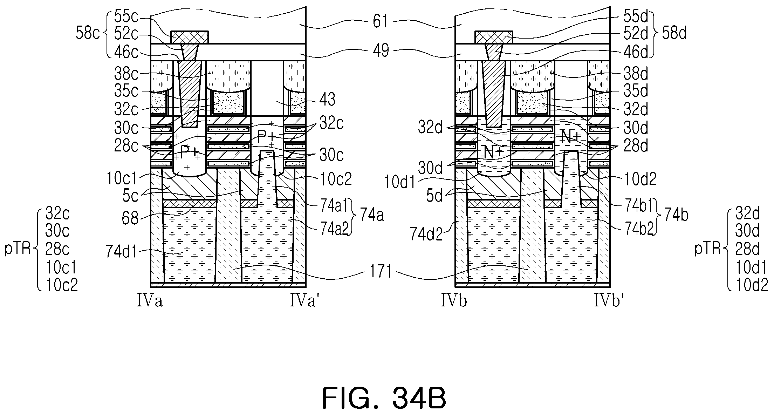

Referring to FIG. 31, FIG. 34A and FIG. 34B, a buffer insulating layer 68 covering the lower surfaces of the first and second semiconductor layers 5c and 5d may be formed, an insulating layer 70 (see FIG. 7B) disposed below the buffer insulating layer 68 may be formed, and an insulating separation structure 71 penetrating through the insulating layer 70, the buffer insulating layer 68 and the first and second semiconductor layers 5c and 5d in the vertical direction (Z-direction) may be formed.

Then, first and second back side conductive patterns 74a and 74b and first and second dummy conductive patterns 74d1 and 74d2 may be formed.

The first back side conductive pattern 74a may include a first portion 74a2 disposed below the buffer insulating layer 68 and penetrating through the insulating layer 70, and a second portion 74a1 extending upwardly from the first portion 74a2 and penetrating through the buffer insulating layer 68 and the first semiconductor layer 5c and electrically connected to the second source/drain pattern 10c2. The second back side conductive pattern 74b may include a first portion 74b2 disposed below the buffer insulating layer 68 and penetrating through the insulating layer 70, and a second portion 74b1 extending upwardly from the first portion 74b2 to penetrate the buffer insulating layer 68 and the second semiconductor layer 5d and electrically connected to the fourth source/drain pattern 10d2.

The first dummy conductive pattern 74d1 may be disposed below the buffer insulating layer 68 and may penetrate through the insulating layer 70, and may vertically overlap the first source/drain pattern 10c1. The second dummy conductive pattern 74d2 may be disposed below the buffer insulating layer 68 and may penetrate through the insulating layer 70, and may vertically overlap the third source/drain pattern 10d1. The first back side conductive pattern 74a and the first dummy conductive pattern 74d1 may be separated from each other by the insulating separation structure 71, and the second back side conductive pattern 74b and the first dummy conductive pattern 74d2 may be separated from each other by the insulating separation structure 71.

The mask pattern 66 (see FIG. 33A) may be removed.

Referring back to FIGS. 1 to 7B, a back side insulating structure 92 and back side interconnection structures 96a and 96b may be formed. The back side interconnection structures 96a and 96b may include a first back side interconnection structure 96a electrically connected to the first back side conductive pattern 74a and a second back side interconnection structure 96b electrically connected to the second back side conductive pattern 74b.

The back side insulating structure 92 may include a first back side etch stop layer 76, a first back side interlayer insulating layer 78, a second back side etch stop layer 82, a second back side interlayer insulating layer 84, a third back side etch stop layer 88, and a third back side interlayer insulating layer 90, which are sequentially formed in a direction away from the passivation structure 65.

The first back side interconnection structure 96a may include a first-first back side interconnection structure 80a electrically connected to the first back side conductive pattern 74a and penetrating through the first back side etch stop layer 76 and the first back side interlayer insulating layer 78, a first-second back side interconnection structure 86a penetrating through the second back side etch stop layer 82 and the second back side interlayer insulating layer 84, and a first-third back side interconnection structure 94a penetrating through the third back side etch stop layer 88 and the third back side interlayer insulating layer 90. The second back side interconnection structure 96b may include a second-first back side interconnection structure 80b electrically connected to the second back side conductive pattern 74b and penetrating through the first back side etch stop layer 76 and the first back side interlayer insulating layer 78, a second-second back side interconnection structure 86b penetrating through the second back side etch stop layer 82 and the second back side interlayer insulating layer 84, and a second-third back side interconnection structure 94b penetrating through the third back side etch stop layer 88 and the third back side interlayer insulating layer 90.

According to some implementations, before forming the second back side etch stop layer 82, a connection contact structure 79 penetrating through the device isolation layer 25, the first and second interlayer insulating layers 43 and 49, the first back side etch stop layer 76, and the first back side interlayer insulating layer 78 may be formed.

According to some implementations, a back side input/output interconnection structure 96io electrically connected to the connection contact structure 79 and embedded in the back side insulating structure 92 may be formed.

According to example implementations, a semiconductor device including a transistor including a channel having a three-dimensional structure and a device including semiconductor regions forming a PN junction may be provided.

According to example implementations, a front side conductive structure on the transistor and a back side interconnection structure below the transistor may be provided. The front side conductive structure and the back side interconnection structure may minimize power paths and signal paths, thereby improving performance of the semiconductor device.

According to example implementations, a passivation structure which may be in contact with a lower surface of a semiconductor body including the semiconductor regions of the device and may prevent or reduce surface defects of the semiconductor body may be provided. The passivation structure may improve performance of the device.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Advantages and effects of the present application are not limited to the foregoing content and may be more easily understood in the process of describing a specific example implementation of the present disclosure.

## Claims

1. A semiconductor device (1), comprising:
a transistor (ptr);
a first device (15a);
a back side insulating structure (92) disposed below the transistor (ptr) and the first device (15a);
a front side conductive structure (58a) disposed on the transistor (ptr) and the first device (15a);
a passivation structure (65) disposed between the first device (15a) and the back side insulating structure (92);
a back side conductive pattern (74a) disposed between the back side insulating structure (92) and the transistor (ptr); and
a back side interconnection structure (96) in the back side insulating structure (92), the back side interconnection structure (96) being electrically connected with the back side conductive pattern (74a),
wherein the transistor (ptr) includes:
a first source/drain pattern (10c1) and a second source/drain pattern (10c2);
a plurality of active layers (28c) disposed between the first source/drain pattern (10c1) and the second source/drain pattern (10c2), the plurality of active layers (28c) being arranged in a vertical direction (Z);
a gate electrode (32c) surrounding each active layer (28c) of the plurality of active layers (28c); and
a gate dielectric layer (30c) between the gate electrode (32c) and the plurality of active layers (28c), and
wherein the first device (15a) includes:
a semiconductor body (5a) including a first semiconductor region (5pa) and a second semiconductor region (5na), the first semiconductor region (5pa) having a first conductivity type, and the second semiconductor region (5na) having a second conductivity type and being configured to form a PN junction with the first semiconductor region (5pa);
a first semiconductor pattern (10pa) disposed on the first semiconductor region (Spa) of the semiconductor body (5a), the first semiconductor pattern (10pa) having the first conductivity type, and an impurity concentration of the first semiconductor pattern (10pa) being higher than an impurity concentration of the first semiconductor region (5pa); and
a second semiconductor pattern (10na) disposed on the second semiconductor region (5na) of the semiconductor body (5a), the second semiconductor pattern (10na) having the second conductivity type, and an impurity concentration of the second semiconductor pattern (10na) being higher than an impurity concentration of the second semiconductor region (5na),
wherein the passivation structure (65) includes a first passivation layer (65a) and a second passivation layer (65b), the first passivation layer (65a) contacts a lower surface of the semiconductor body (5a), and the second passivation layer (65b) is disposed below the first passivation layer (65a),
wherein a thickness of the second passivation layer (65b) is greater than a thickness of the first passivation layer (65a), and
wherein the first conductivity type is a P-type and the second conductivity type is an N-type, or the first conductivity type is the N-type and the second conductivity type is the P-type.

2. The semiconductor device (1) of claim 1,
wherein the passivation structure (65) is disposed outside an area between the back side insulating structure (92) and the transistor (ptr).

3. The semiconductor device (1) of claim 1 or 2,
wherein the first passivation layer (65a) includes a first dielectric, and
wherein the second passivation layer (65b) includes a second dielectric, a dielectric constant of the second dielectric being higher than a dielectric constant of the first dielectric.

4. The semiconductor device (1) of any one of claims 1 to 3,
wherein at least a portion of the back side conductive pattern (74) and at least a portion of the semiconductor body (5a) are at the same level.

5. The semiconductor device (1) of any one of claims 1 to 4, further comprising:
a semiconductor layer (5c) disposed between the back side insulating structure (92) and the transistor (ptr),
wherein the first source/drain pattern (10c1) and the second source/drain pattern (10c2) contact the semiconductor layer (5c), and
wherein the back side conductive pattern (74) extends through the semiconductor layer (5c) and is electrically connected with the second source/drain pattern (10c2).

6. The semiconductor device (1) of any one of claims 1 to 5, further comprising:
an intermediate insulating structure (369) between the transistor (ptr) and the back side insulating structure (92),
wherein the back side conductive pattern (74, 374a) extends through the intermediate insulating structure (369) and is electrically connected with the second source/drain pattern (10c2).

7. The semiconductor device (1) of claim 6, further comprising:
a buffer semiconductor pattern (509c) contacting a lower surface of the first source/drain pattern (10c1).

8. The semiconductor device (1) of any one of claims 1 to 7,
wherein the semiconductor body (5a) has a bar shape extending in a first direction (X),
wherein the semiconductor body (5a) includes a plurality of first semiconductor regions (5pa),
wherein the semiconductor body (5a) includes a plurality of second semiconductor regions (5na), and
wherein the plurality of first semiconductor regions (5pa) and the plurality of second semiconductor regions (5na) are arranged alternately in the first direction (X).

9. The semiconductor device (1) of any one of claims 1 to 8,
wherein the semiconductor body (5a) has a bar shape extending in a first direction (X),
wherein the semiconductor body (5a) includes a plurality of first semiconductor regions (5pa),
wherein the semiconductor body (5a) includes a plurality of second semiconductor regions (5na),
wherein the plurality of first semiconductor regions (5pa) and the plurality of second semiconductor regions (5na) are arranged alternately in the first direction (X),
wherein the semiconductor body (5a) includes a plurality of connection semiconductor regions (105pac), the plurality of connection semiconductor regions (105pac) extending below the plurality of first semiconductor regions (Spa) from a plurality of lower regions of the plurality of second semiconductor regions (5na), and the plurality of connection semiconductor regions (105pac) having the first conductivity type, and
wherein the plurality of second semiconductor regions (5na) are disposed on the plurality of connection semiconductor regions (105pac), respectively.

10. The semiconductor device (1) of any one of claims 1 to 9,
wherein the semiconductor body (5a) includes a plurality of first semiconductor regions (5pa),
wherein the semiconductor body (5a) includes a plurality of second semiconductor regions (5na),
wherein a plurality of first semiconductor patterns (10pa) are disposed on at least one of the first semiconductor regions (Spa), and
wherein the first device (15a) includes a plurality of second semiconductor patterns (10na).

11. The semiconductor device (1) of any one of claims 1 to 10,
wherein the semiconductor body (5a) includes a plurality of first semiconductor regions (5pa),
wherein the semiconductor body (5a) includes a plurality of second semiconductor regions (5na),
wherein a plurality of first semiconductor patterns (10pa) are disposed on the plurality of first semiconductor regions (Spa), one of the first semiconductor patterns (10pa) being disposed on one of the first semiconductor regions (Spa), and
wherein the first device (15a) includes a plurality of second semiconductor patterns (10na).

12. The semiconductor device (1) of any one of claims 1 to 11, further comprising:
a plurality of dummy active structures (28a) on the semiconductor body (5a),
wherein the semiconductor body (5a) includes a plurality of first semiconductor regions (5pa),
wherein the semiconductor body (5a) includes a plurality of second semiconductor regions (5na),
wherein the first device (15a) includes a plurality of first semiconductor patterns (10pa),
wherein the first device (15a) includes a plurality of second semiconductor patterns (10na),
wherein each dummy active structure (28a) of the plurality of dummy active structures (28a) is disposed between two adjacent semiconductor patterns among the plurality of first semiconductor patterns (10pa) and the plurality of second semiconductor patterns (10na), and
wherein each dummy active structure (28a) of the plurality of dummy active structures (28a) includes a plurality of dummy active layers (28a) arranged in the vertical direction (Z).

13. The semiconductor device (1) of claim 12, further comprising:
a plurality of first gate structures (40a) on the plurality of dummy active structures (28a), respectively,
wherein each first gate structure (40a) of the plurality of first gate structures (40a) includes a first gate electrode (32a), the first gate electrode (32a) surrounds a respective dummy active layer (28a) of the plurality of dummy active layers (28a), and a first gate dielectric layer (30a) is between the dummy active layer (28a) and the first gate electrode (32a).

14. The semiconductor device (1) of claim 12 or 13, further comprising:
a plurality of dummy insulating structures (30a) on the plurality of dummy active structures (28a), respectively,
wherein each dummy insulating structure (30a) of the plurality of dummy insulating structures (30a) surrounds a respective dummy active layer (28a) of the plurality of dummy active layers (28a), and
wherein the plurality of dummy insulating structures (30a) do not include a conductive material and are at a same level as the gate electrode (32c).

15. The semiconductor device (1) of any one of claims 1 to 14, wherein at least a portion of one of the first and second source/drain patterns (10c1, 10c2) is at the same level as at least a portion of one of the first and second semiconductor patterns (10pa, 10na).
